# EUROPEAN PATENT APPLICATION

(11) **EP 4 379 977 A1**
(43) Date of publication of application: **05.06.2024**
(21) Application number: 22849519.8
(22) Date of filing: 27.07.2022
(51) Int. Cl.: H01S 5/02, H01S 5/343

(54) **SEMICONDUCTOR DEVICE MANUFACTURING METHOD, TEMPLATE SUBSTRATE, SEMICONDUCTOR DEVICE, ELECTRONIC EQUIPMENT, AND SEMICONDUCTOR DEVICE MANUFACTURING APPARATUS**

(30) Priority: 30.07.2021 JP 2021125395
(71) Applicant: Kyocera Corporation, Kyoto-shi Kyoto 612-8501 (JP)
(72) Inventor: MURAKAWA, Kentaro, Kyoto-shi, Kyoto 612-8501 (JP); KAMIKAWA, Takeshi, Kyoto-shi, Kyoto 612-8501 (JP); KAWAGUCHI, Yoshinobu, Kyoto-shi, Kyoto 612-8501 (JP)
(74) Representative: Viering, Jentschura & Partner mbB Patent- und Rechtsanwälte
(86) International application number: PCT/JP2022/028868
(87) International publication number: WO 2023/008458

(57) **Abstract**

A manufacturing method for a semiconductor device includes a step of preparing a main substrate, a base semiconductor part formed above the main substrate, and a compound semiconductor part formed on the base semiconductor part, and a step of isolating the base semiconductor part and the compound semiconductor part with a cavity surface formed at least in the compound semiconductor part, and isolating the base semiconductor part and the compound semiconductor part into multiple element portions.

## Description

### TECHNICAL FIELD

The present disclosure relates to a manufacturing method for a semiconductor device and the like.

### BACKGROUND OF INVENTION

When semiconductor devices such as laser diode elements are miniaturized, handling of the semiconductor devices becomes difficult. Patent Document 1 describes a technique related to handling of laser diode elements.

### CITATION LIST

### PATENT LITERATURE

Patent Document 1: JP 2008-252069 A

### SUMMARY

A method for manufacturing a semiconductor device according to an aspect of the present disclosure includes preparing a main substrate, a base semiconductor part formed above the main substrate, and a compound semiconductor part formed on the base semiconductor part, and isolating the base semiconductor part and the compound semiconductor part with a cavity surface formed at least in the compound semiconductor part, and isolating the base semiconductor part and the compound semiconductor part into multiple element portions.

A method for manufacturing a semiconductor device according to another aspect of the present disclosure includes preparing a main substrate, a base semiconductor part formed above the main substrate, and a compound semiconductor part formed on the base semiconductor part, and forming multiple optical cavities, each of the multiple optical cavities including a cavity surface by dividing both the base semiconductor part and the compound semiconductor part. In the forming of the multiple optical cavities, the main substrate is not divided, or the main substrate is divided into fewer pieces than the multiple optical cavities.

A template substrate according to still another aspect of the present disclosure includes a main substrate, a seed part, and a mask. The mask includes an opening portion having a longitudinal shape and a mask portion, and a notch is provided in the opening portion.

According to yet another aspect of the present disclosure, a semiconductor device includes a base semiconductor part, and a compound semiconductor part located above the base semiconductor part and including an optical cavity including a pair of cavity surfaces. The base semiconductor part and the compound semiconductor part include a GaN-based semiconductor. The base semiconductor part includes a cleavage plane being an m-plane of the GaN-based semiconductor.

### BRIEF DESCRIPTION OF THE DRAWINGS

FIG. 1 is a perspective view for explaining a structure of a laser diode element according to an embodiment of the present disclosure.
FIG. 2 is a perspective view for explaining an optical cavity included in the laser diode element.
FIG. 3 is a flowchart illustrating an example of a manufacturing method for the laser diode element according to the embodiment of the present disclosure.
FIG. 4 illustrates a plan view and a cross-sectional view of a configuration of a template substrate according to the embodiment of the present disclosure.
FIG. 5 illustrates cross-sectional views for explaining a semiconductor substrate according to the embodiment of the present disclosure.
FIG. 6A is a plan view for explaining an example of a step of element isolation.
FIG. 6B is a cross-sectional view taken along a line B-VI illustrated in FIG. 6A.
FIG. 7 is a flowchart illustrating an example of a mounting stage in the manufacturing method for the laser diode element according to the embodiment of the present disclosure.
FIG. 8 is a block diagram illustrating an example of a manufacturing apparatus.
FIG. 9 is a flowchart illustrating an example of a manufacturing method for the laser diode element in Example 1.
FIG. 10 is a cross-sectional view illustrating a configuration of the template substrate in Example 1.
FIG. 11A is an enlarged view of a main portion in FIG. 10.
FIG. 11B is a plan view illustrating an example of a starting point inducing portion in Example 1.
FIG. 11C is a plan view illustrating another example of the starting point inducing portion in Example 1.
FIG. 11D is a plan view illustrating still another example of the starting point inducing portion in Example 1.
FIG. 11E is a plan view illustrating yet another example of the starting point inducing portion in Example 1.
FIG. 12 illustrates cross-sectional views of an example of lateral growth of a base semiconductor layer in Example 1.
FIG. 13 is a plan view for explaining the base semiconductor layer in Example 1.
FIG. 14 illustrates enlarged views for explaining how the base semiconductor layer grows around the starting point inducing portion in Example 1.
FIG. 15 is a cross-sectional view illustrating a configuration of a compound semiconductor layer in Example 1.
FIG. 16 is a plan view for explaining the compound semiconductor layer in Example 1.
FIG. 17 is a plan view for explaining an example of a step of element isolation in Example 1.
FIG. 18 is an exploded perspective view for explaining a configuration of a semi-element portion in Example 1.
FIG. 19 is a perspective view for explaining a configuration of an element portion in Example 1.
FIG. 20 is a cross-sectional view illustrating the configuration of the element portion in Example 1.
FIG. 21 schematically illustrates cross-sectional views of several steps of separating the element portion from the template substrate in the manufacturing method for the laser diode element in Example 1.
FIG. 22 is a perspective view schematically illustrating a state in which the element portion is bonded to a support substrate.
FIG. 23 is a cross-sectional view schematically illustrating the state in which the element portion DS is bonded to the support substrate SK.
FIG. 24 schematically illustrates cross-sectional views of several steps of forming a reflection film on a cavity surface in the manufacturing method for the laser diode element in Example 1.
FIG. 25 is a plan view illustrating a configuration of the compound semiconductor layer after depositing a reflector film.
FIG. 26 schematically illustrates cross-sectional views of several steps of dividing the support substrate in the manufacturing method for the laser diode element in Example 1.
FIG. 27 is a plan view for explaining yet another example of the base semiconductor layer in Example 1.
FIG. 28 is an exploded perspective view for explaining another configuration example of the semi-element portion in Example 1.
FIG. 29 is a cross-sectional view illustrating a configuration of the laser diode element in Example 2.
FIG. 30 illustrates schematic cross-sectional views of an example of a manufacturing method for the laser diode element in Example 2.
FIG. 31 is a flowchart illustrating an example of a manufacturing method for the laser diode element in Example 3.
FIG. 32 is a plan view illustrating a configuration of the semiconductor substrate in which the base semiconductor layer is deposited in Example 3.
FIG. 33 is a plan view illustrating a configuration of the semiconductor substrate in which the element structure is formed in Example 3.
FIG. 34 is a cross-sectional view illustrating the configuration of the semiconductor substrate in FIG. 33.
FIG. 35 illustrates plan views of an example of element isolation in Example 4.
FIG. 36 is a schematic view illustrating a configuration of an electronic device in Example 5.

### DESCRIPTION OF EMBODIMENTS

An embodiment of the present disclosure will be described below with reference to the accompanying drawings. Note that the following description is for better understanding of the gist of the present disclosure and does not limit the present disclosure unless otherwise specified. Unless otherwise specified in this specification, "from A to B" representing a numerical value range means "A or more and B or less". Shapes and dimensions (length, width, and the like) of configurations illustrated in each of the drawings in the present application do not necessarily reflect actual shapes and dimensions, and are appropriately changed for clarification and simplification of the drawings.

In the embodiment of the present disclosure, an LD (laser diode) element will be described as an example of a semiconductor device, but the semiconductor device of the present disclosure is not necessarily limited thereto. The semiconductor device of the present disclosure may be, for example, a sensor including an optical cavity or a sensor on which cavity surfaces are formed.

In the following description, first, a structure of the laser diode element according to the embodiment of the present disclosure will be outlined, and then a manufacturing method for the laser diode element according to the embodiment of the present disclosure will be described in detail.

### Laser Diode Element

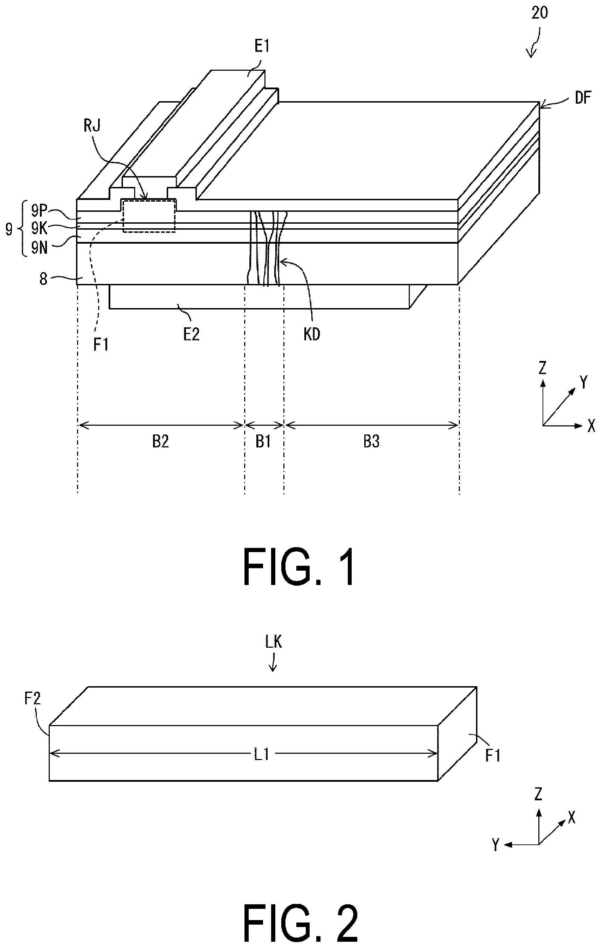

A laser diode element 20 according to the embodiment of the present disclosure will be described below with reference to FIGs. 1 and 2. FIG. 1 is a perspective view for explaining a structure of the laser diode element 20. FIG. 2 is a perspective view for explaining an optical cavity LK included in the laser diode element 20. Note that FIG. 1 illustrates an example, and the laser diode element 20 may have a shape in which a depth direction in the perspective view illustrated in FIG. 1 is a longitudinal direction.

The laser diode element 20 according to the embodiment of the present disclosure has a structure including electrodes on an upper side and a lower side (hereinafter referred to as a "double-sided electrode structure"), but is not limited thereto. For example, the laser diode element 20 may have a structure including two electrodes (anode and cathode) on the upper side (hereinafter referred to as a "single-sided two-electrode structure"). The laser diode element 20 may be mounted on a support substrate (also referred to as a submount), and the support substrate is omitted in FIG. 1.

As illustrated in FIGs. 1 and 2, the laser diode element (semiconductor device) 20 according to the present embodiment includes a base semiconductor part 8, a compound semiconductor part 9 located above the base semiconductor part 8 and including the optical cavity LK, a first electrode E1, a second electrode E2, and an insulating film DF. In the optical cavity LK, a surface from which a laser beam is emitted is referred to as an emission surface F1, and a surface facing the emission surface F1 is referred to as a facing surface F2. The emission surface F1 and the facing surface F2 are a pair of optical cavity surfaces in the optical cavity LK. Note that a specific aspect (element structure) of the optical cavity LK is not limited.

The base semiconductor part 8 and the compound semiconductor part 9 typically are layered. Accordingly, the base semiconductor part 8 can also be referred to as a base semiconductor layer 8, and the compound semiconductor part 9 can also be referred to as a compound semiconductor layer 9. In the following, the base semiconductor part 8 and the compound semiconductor part 9 are referred to as the base semiconductor layer 8 and the compound semiconductor layer 9, respectively, but the base semiconductor layer 8 and the compound semiconductor layer 9 are not necessarily limited to layers.

The base semiconductor layer 8 may contain, for example, a nitride semiconductor. The nitride semiconductor may be expressed, for example, as AlxGayInzN (0 ≤ x ≤ 1; 0 ≤ y ≤ 1; 0 ≤ z ≤ 1; x + y + z = 1). Specific examples of the nitride semiconductor include a GaN (gallium nitride)-based semiconductor, AlN (aluminum nitride), InAlN (indium aluminum nitride), and InN (indium nitride). The GaN-based semiconductor is a semiconductor containing Ga (gallium) atoms and N (nitrogen) atoms. Typical examples of the GaN-based semiconductor may include GaN, AlGaN, AlGaInN, and InGaN. The base semiconductor layer 8 may be a doped (e.g., n-type with a donor) layer or a non-doped layer.

The compound semiconductor layer 9 may contain, for example, the nitride semiconductor described above. In general, it is difficult to reduce the defect density of nitride semiconductors. The fewer surface defects in the base semiconductor layer 8, the fewer dislocations (defects) transferred from the base semiconductor layer 8 to the compound semiconductor layer 9. Thus, the defect density of the compound semiconductor layer 9 can be reduced. The laser diode element 20 according to the present embodiment may include, as the base semiconductor layer 8, a semiconductor layer formed by an epitaxial lateral overgrowth (ELO) method (hereinafter, may be referred to as an ELO semiconductor layer). Note that the base semiconductor layer 8 is not limited to the ELO semiconductor layer as long as the base semiconductor layer 8 can reduce the defect density of the optical cavity LK included in the compound semiconductor layer 9.

A technique for manufacturing the base semiconductor layer 8 is not limited. For example, the base semiconductor layer 8 may be a general semiconductor layer containing a nitride semiconductor. This "general semiconductor layer" means a semiconductor layer epitaxially grown vertically on a growth substrate. In this specification, such a general semiconductor layer may be referred to as a "GE semiconductor layer" for convenience of description. The GE semiconductor layer can be formed by a known method, so a description thereof will be omitted.

In this specification, a substrate used for growing various semiconductor layers included in the laser diode element may be referred to as a "growth substrate".

In the present embodiment, as illustrated in FIG. 1, the laser diode element 20 in which the base semiconductor layer 8 is an ELO semiconductor layer will be described. A manufacturing method for the base semiconductor layer 8 using the ELO method will be described later.

The base semiconductor layer 8, which is the ELO semiconductor layer, includes a first part (first portion) B 1, and a second part (second portion) B2 and a third part (third portion) B3 in which a density of threading dislocations KD extending in a thickness direction (Z direction) (threading dislocation density) is smaller than that in the first part B 1. The second part B2, the first part B 1, and the third part B3 are aligned in this order in an X direction, and the first part B 1 is located between the second part B2 and the third part B3. The threading dislocation KD is a dislocation (defect) extending from a lower surface or inside of the base semiconductor layer 8 to a front surface or surface layer thereof along the thickness direction of the base semiconductor layer 8. The threading dislocation densities of the second part B2 and the third part B3 may be one fifth or less (e.g., 5 × 10⁶/cm² or less) of the threading dislocation density of the first part B 1.

In the laser diode element 20, the compound semiconductor layer 9 including multiple layers is layered on the base semiconductor layer 8, and a layering direction thereof may be defined as an "upward direction". In the following, in XYZ coordinate axes illustrated in FIG. 1, a positive side in the Z-axis direction may be referred to as "upper side", and a negative side in the Z-axis direction may be referred to as "lower side". A surface of each member on the positive side in the Z-axis direction may be referred to as "upper surface", and a surface of each member on the negative side in the Z-axis direction may be referred to as "lower surface". Regarding a substrate-shaped or substantially substrate-shaped object such as the laser diode element 20, viewing the object with a line of sight parallel to a normal direction of an upper surface can be referred to as "viewing in plan". Although not described repeatedly below, in other figures, the vertical direction may be similarly defined and the expression "in plan view" may be used.

The compound semiconductor layer 9 includes an n-type semiconductor part (first type semiconductor part) 9N, an active part 9K, and a p-type semiconductor part (second type semiconductor part) 9P in this order upward from the base semiconductor layer 8. The n-type semiconductor part 9N, the active part 9K, and the p-type semiconductor part 9P typically are layered. Accordingly, the n-type semiconductor part 9N can also be referred to as an n-type semiconductor layer 9N. The active part 9K can also be referred to as an active layer 9K. The p-type semiconductor part 9P can also be referred to as a p-type semiconductor layer 9P. In the following, the n-type semiconductor part 9N, the active part 9K, and the p-type semiconductor part 9P are referred to as the n-type semiconductor layer 9N, the active layer 9K, and the p-type semiconductor layer 9P, respectively, but the n-type semiconductor layer 9N, the active layer 9K, and the p-type semiconductor layer 9P are not necessarily limited to layers.

The p-type semiconductor layer 9P may include a ridge portion RJ. The n-type semiconductor layer 9N, the active layer 9K, and the p-type semiconductor layer 9P may contain the nitride semiconductor described above. The various layers included in the compound semiconductor layer 9 will be specifically described later. The compound semiconductor layer 9 may have a higher threading dislocation density above the first part B1 due to the influence of the first part B1 of the base semiconductor layer 8.

The compound semiconductor layer 9 includes the optical cavity LK at a position overlapping the second part B2 in plan view. The optical cavity LK includes a waveguide extending between the emission surface F1 and the facing surface F2 constituting the pair of cavity surfaces. A distance between the emission surface F1 and the facing surface F2 can be a cavity length (resonance length) L1 of the optical cavity LK. An end surface of the active layer 9K included in the emission surface F1 and an end surface of the active layer 9K included in the facing surface F2 may each be coated with a reflection film (e.g., dielectric film).

In the laser diode element 20, the emission surface F1 and/or the facing surface F2 may be an m-plane or a c-plane of the compound semiconductor layer 9 containing a nitride semiconductor. In FIG. 1 and other figures, in the XYZ coordinate axes, a positive direction of an X-axis can be a [11-20] direction of the nitride semiconductor, a positive direction of a Y-axis can be a [-1100] direction of the nitride semiconductor, and the positive direction of the Z-axis (thickness direction) can be a [0001] direction of the nitride semiconductor. The m-plane that the emission surface F1 and/or the facing surface F2 may include is a plane parallel to a (1-100) plane (or a (-1100) plane) of the nitride semiconductor. The c-plane that the emission surface F1 and/or the facing surface F2 may include is a plane parallel to a (0001) plane of the nitride semiconductor.

In the laser diode element 20, the emission surface F1 and/or the facing surface F2 may be included in a cleavage plane of the compound semiconductor layer 9. Both of the emission surface F1 and the facing surface F2 may be included in the cleavage planes of the compound semiconductor layer 9. The laser diode element 20 may have a cavity length L1 of 200 [µm] or less.

The laser diode element 20 includes the first electrode E1 and the second electrode E2 for supplying current to the optical cavity LK. The first electrode E1 can be positioned so as to overlap the optical cavity LK in plan view viewed in the thickness direction of the base semiconductor layer 8. Note that "two members overlap" in plan view means that at least part of one member overlaps the other member in plan view (including perspective plan view) viewed in a thickness direction of both members, and these members may or may not be in contact with each other.

The first electrode E1 may be located above the compound semiconductor layer 9, may have a shape that overlaps at least part of the ridge portion RJ in plan view, and extends along the longitudinal direction of the optical cavity LK. The first electrode E1 is electrically connected to the ridge portion RJ in the p-type semiconductor layer 9P and functions as an anode. The first electrode E1 and the ridge portion RJ may be in contact with each other, or may be connected with another layer interposed therebetween.

The second electrode E2 may be located below the compound semiconductor layer 9, for example, on the lower surface of the base semiconductor layer 8. The second electrode E2 may have a shape overlapping at least part of the first electrode E1 in plan view. The second electrode E2 is electrically connected to the base semiconductor layer 8 and functions as a cathode. The second electrode E2 and the base semiconductor layer 8 may be in contact with each other, or may be connected with another layer interposed therebetween. The second electrode E2 may be in contact with the compound semiconductor part 9 (e.g., the n-type semiconductor layer 9N).

The insulating film DF is located above the compound semiconductor layer 9. The insulating film DF may cover an upper surface of the p-type semiconductor layer 9P except for a contact portion between the first electrode E1 and the ridge portion RJ.

### Manufacture of Laser Diode Element

Laser diodes may be manufactured from a laminate body including multiple semiconductor layers (referred to as a known technique CT). In the known technique CT, multiple laser diodes are formed on a growth substrate, and the multiple laser diodes are divided together with the growth substrate.

The inventors have diligently studied a technique different from the known technique CT, and have arrived at a manufacturing method for a laser diode element according to the present disclosure. The laser diode element 20 according to the present embodiment is manufactured by a technique that, in outline, includes a step of forming an optical cavity on a growth substrate (forming cavity surfaces in at least the compound semiconductor layer 9).

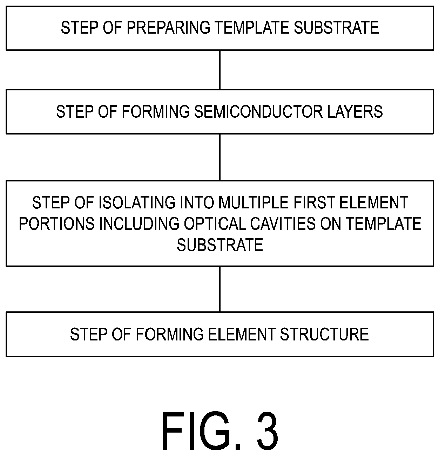

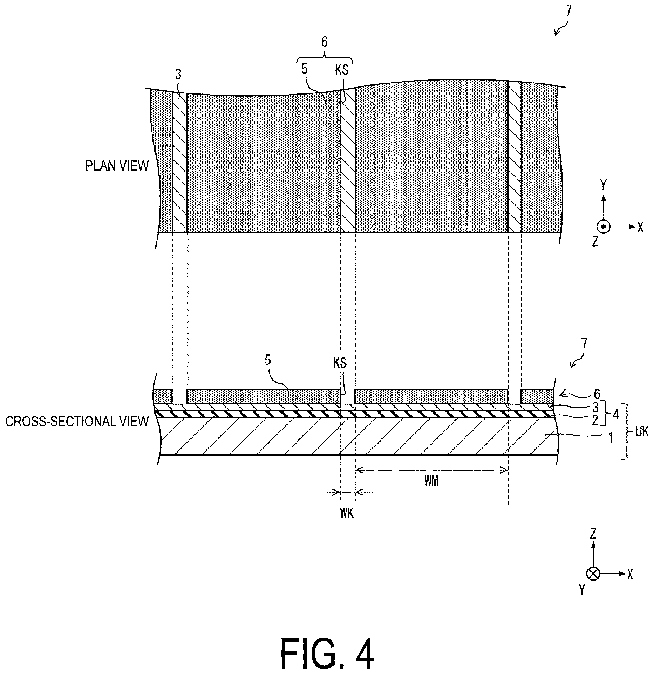

In the following, a manufacturing method for a laser diode element (a laser diode element in which the base semiconductor layer 8 is an ELO semiconductor layer) according to the embodiment of the present disclosure will be described. FIG. 3 is a flowchart illustrating an example of the manufacturing method for the laser diode element according to the present embodiment. FIG. 4 illustrates a plan view and a cross-sectional view of a configuration of a template substrate according to the present embodiment.

### Step of Preparing Template Substrate

As illustrated in FIG. 3, in the manufacturing method for the laser diode element according to the embodiment of the present disclosure, first, the template substrate is prepared. As illustrated in FIG. 4, a template substrate 7 according to the present embodiment includes a main substrate 1, an underlying part 4 located above the main substrate 1, and a mask 6 located above the main substrate 1 and including an opening portion KS and a mask portion 5. In the following, the main substrate 1 and the underlying part 4 may be collectively referred to as an underlying substrate UK. The underlying substrate UK and the template substrate 7 are examples of the above-described growth substrate.

The underlying part 4 and the mask 6 typically are layered. Accordingly, the underlying part 4 can also be referred to as an underlying layer 4, and the mask 6 can also be referred to as a mask layer 6. Although the underlying part 4 and the mask 6 are referred to as the underlying layer 4 and the mask layer 6, respectively in the following, the underlying layer 4 and the mask layer 6 are not necessarily limited to layers. The mask 6 may be a mask pattern including the mask portion 5 and the opening portion KS. The opening portion KS is an area where the mask portion 5 does not exist, and the opening portion KS does not need to be surrounded by the mask portion 5.

A heterogeneous substrate having a lattice constant different from that of a nitride semiconductor may be used for the main substrate 1. Examples of the heterogeneous substrate include a silicon (Si) substrate, a sapphire (Al₂O₃) substrate, and a silicon carbide (SiC) substrate. A plane orientation of the main substrate 1 is, for example, a (111) plane of the Si substrate, a (0001) plane of the Al₂O₃ substrate, or a 6H-SiC (0001) plane of the SiC substrate. However, these are merely examples, and the main substrate 1 is not limited as long as the main substrate 1 is a substrate having a plane orientation on which the base semiconductor layer 8 can be grown by the ELO method.

The template substrate 7 may include a buffer part 2 and a seed part 3 as the underlying layer 4 in order from the main substrate 1 side. The buffer part 2 and the seed part 3 typically are layered. Accordingly, the buffer part 2 can also be referred to as a buffer layer 2, and the seed part 3 can also be referred to as a seed layer 3. Although the buffer part 2 and the seed part 3 are referred to as the buffer layer 2 and the seed layer 3, respectively in the following, the buffer layer 2 and the seed layer 3 are not necessarily limited to layers.

The buffer layer 2 is a melting suppression layer that can reduce the likelihood of the main substrate 1 and the seed layer 3 melting when they come into direct contact with each other. The buffer layer 2 also has an effect of enhancing the crystallinity of the seed layer 3. The seed layer 3 is a layer that serves as a growth starting point for the base semiconductor layer 8 when depositing the base semiconductor layer 8, as described later. Note that, for example, when using the main substrate 1 that does not melt together with the seed layer 3, which is a GaN-based semiconductor, a configuration without the buffer layer 2 is also possible. On the other hand, when a Si substrate or the like is used as the main substrate 1, due to contact between the GaN-based semiconductor contained in the seed layer 3 and the Si substrate, the GaN-based semiconductor and the Si substrate may melt together. Accordingly, for example, the buffer layer 2 such as an AlN layer or a SiC layer is provided. This can reduce the likelihood of the GaN-based semiconductor and the Si substrate melting.

The mask layer 6 formed on the underlying substrate UK includes multiple mask portions 5 and multiple opening portions KS. Both the mask portion 5 and the opening portion KS may have longitudinal shapes with a first direction (X direction) as a width direction and a second direction (Y direction) as a longitudinal direction. The opening portion KS may have a tapered shape (tapering downward). As the mask layer 6, an inorganic insulating film such as a SiOx (silicon oxide) film, a SiNx (silicon nitride) film, a SiON (silicon oxynitride) film, a TiNx (titanium nitride) film or the like may be used. For the mask layer 6, a laminate film including the above-described materials may be used. For example, a laminate film including a silicon oxide film and a silicon nitride film may also be used.

The mask layer 6 may be formed, for example, as follows. That is, a SiO₂ film is formed on an entire surface of the underlying substrate UK by sputtering, and then wet-etched while partially protected with a resist. By removing some portions of the SiO₂ film, the mask portions 5 and the opening portions KS are formed.

The opening portion KS in the mask layer 6 functions as a growth initiation hole to expose the seed layer 3 and initiate the growth of the base semiconductor layer 8. The mask portion 5 in the mask layer 6 functions as a selective growth mask for lateral growth of the base semiconductor layer 8. A width WK of the opening portion KS may be, for example, about 0.1 µm to 20 µm. The narrower the width of the opening portion KS, the smaller the number of threading dislocations that propagate through the opening portion KS to the base semiconductor layer 8. Further, the base semiconductor layer 8 may be easily peeled off in a post-step. Areas of the second part B2 and the third part B3, which have fewer surface defects, may be increased. A width WM of the mask portion 5 may be about 25 µm to 200 µm.

In the manufacturing method for the laser diode element according to the present embodiment, for example, in the step of preparing the template substrate 7, the mask layer 6 may be formed so that the opening portion KS has a shape with a notch, in other words, the mask portion 5 has a shape partially protruding in the X direction. Hereinafter, a portion of the mask portion 5 partially protruding in the X direction is referred to as a starting point inducing portion. With the mask layer 6 including the starting point inducing portion, the base semiconductor layer 8 and the compound semiconductor layer 9 can be formed on the template substrate 7 so as to include starting portions serving as starting points of cleavage. Details will be described in Example 1 below.

### Step of Forming Semiconductor Layers

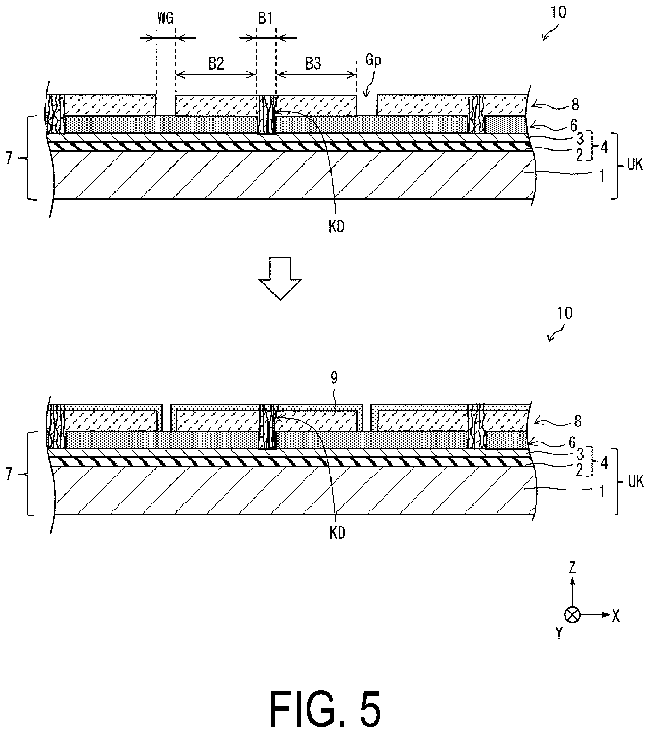

FIG. 5 illustrates cross-sectional views for explaining the semiconductor substrate according to the present embodiment. The manufacturing method for the laser diode element according to an aspect of the present disclosure may include a step of forming semiconductor layers (see FIG. 3). In the step of forming semiconductor layers, for example, the base semiconductor layer 8 is formed on the template substrate 7 by the ELO method, and then the compound semiconductor layer 9 is formed above the base semiconductor layer 8.

In the ELO method, for example, with an inorganic compound film such as a SiO₂ film as the mask layer 6, the base semiconductor layer 8 can be laterally grown on the mask portion 5 using the seed layer 3 containing the GaN-based semiconductor. The thickness direction (Z direction) of the base semiconductor layer 8 formed by the ELO method can be the <0001> direction (c-axis direction) of a GaN-based crystal, the width direction (X direction) of the opening portion KS can be the <11-20> direction (a-axis direction) of the GaN-based crystal, and the longitudinal direction (Y direction) of the opening portion KS can be the <1-100> direction (m-axis direction) of the GaN-based crystal.

As illustrated in FIG. 5, the base semiconductor layer 8 includes the second part B2 and the third part B3 that overlap the mask portion 5 in plan view and have relatively few threading dislocations KD, and the first part B 1 that overlaps the opening portion KS in plan view and has more threading dislocations KD than the second part B2 and the third part B3. Due to the influence of the threading dislocations KD present on a surface of the first part B1, the compound semiconductor layer 9 contains many threading dislocations KD above the first part B 1. The optical cavity LK can be provided so as to overlap the second part B2 in plan view. This can reduce the likelihood of the performance of the optical cavity LK deteriorating due to the influence of the threading dislocations KD. This is because, in the compound semiconductor layer 9 on the second part B2, the number of dislocations (defects) taken in due to surface defects in the second part B2 during deposition of the compound semiconductor layer 9 is relatively small.

The threading dislocation KD is a dislocation (defect) extending from the lower surface or inside of the base semiconductor layer 8 to the front surface or surface layer thereof along the thickness direction of the base semiconductor layer 8. The threading dislocation KD may be observed by, for example, performing CL (cathode luminescence) measurement on the surface of the base semiconductor layer 8 (parallel to the c-plane).

The second part B2 or the third part B3 can be configured such that a non-threading dislocation density in a cross section parallel to the <0001> direction is greater than a threading dislocation density in an upper surface. The non-threading dislocation is a dislocation measured by CL in a cross section taken along a plane parallel to the thickness direction, and is mainly a basal plane (c-plane) dislocation.

The semiconductor substrate 10 according to the present embodiment may include the template substrate 7 and the base semiconductor layer 8 formed on the template substrate 7. The semiconductor substrate 10 may include the template substrate 7, the base semiconductor layer 8, and the compound semiconductor layer 9 formed above the base semiconductor layer 8.

In the semiconductor substrate 10 according to the present embodiment, multiple base semiconductor layers 8 are formed so as to have a gap Gp between different base semiconductor layers 8. A width WG of the gap Gp may be 4 µm or less, or may be 3 µm or less. Note that the semiconductor substrate 10 is not limited to having the gap Gp, and the base semiconductor layers 8 grown laterally from the seed layer 3 exposed in the two adjacent opening portions KS may be in contact with each other on the mask portion 5.

When forming the base semiconductor layer 8 using the ELO method, the template substrate 7 including the main substrate 1 and the mask layer 6 on the main substrate 1 may be used, and the template substrate 7 may have a growth suppression area (e.g., an area that suppresses crystal growth in the Z direction) corresponding to the mask portion 5 and a seed area corresponding to the opening portion KS. For example, the growth suppression area and the seed area may be formed on the main substrate 1, and the base semiconductor layer 8 may be formed on the growth suppression area and the seed area using the ELO method.

### Step of Element Isolation on Template Substrate

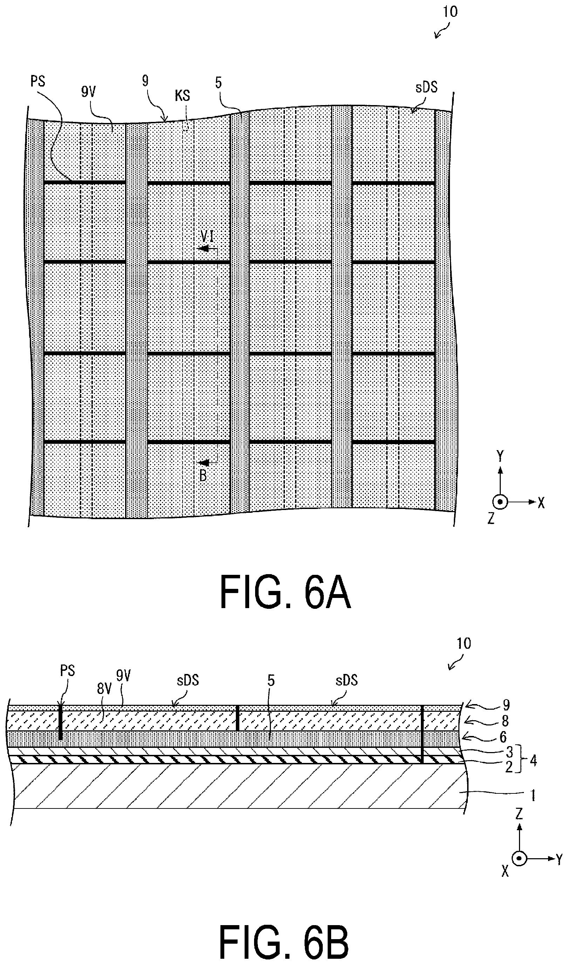

FIG. 6A is a plan view for explaining an example of a step of element isolation. FIG. 6B is a cross-sectional view taken along a line B-VI illustrated in FIG. 6A.

In the manufacturing method for the laser diode element according to the present embodiment, the base semiconductor layer 8 and the compound semiconductor layer 9 may be isolated into multiple semi-element portions (first element portions) sDS on the template substrate 7 so as to form cavity surfaces at least in the compound semiconductor layer 9. "Semi-element portion sDS" means a portion (laminate body) including a single piece 8V of the base semiconductor layer 8 and a single piece 9V of the compound semiconductor layer 9 located above the single piece 8V of the base semiconductor layer 8 among multiple pieces aligned along the Y-axis direction, which are formed by dividing the base semiconductor layer 8 and the compound semiconductor layer 9 on the template substrate 7. The semi-element portion sDS can be said to be a type of element portion, but in that the semi-element portion sDS does not include members such as electrodes for driving the semi-element portion sDS as an element, the semi-element portion sDS may be in a state in which the element portion as a product is in the middle of being manufactured, that is, may be positioned as a semi-finished product. Such a semi-element portion sDS also falls within a category of the semiconductor device in the present disclosure. A boundary between adjacent semi-element portions sDS is referred to as a dividing portion PS, and the dividing portion PS is indicated by a thick black line in FIGs. 6A and 6B.

In this specification, isolating the base semiconductor layer 8 and the compound semiconductor layer 9 into the multiple semi-element portions sDS on the template substrate 7 may be referred to as "element isolation". "Element isolation" means the following (i) and (ii). (i) At a time when the base semiconductor layer 8 and the compound semiconductor layer 9 are isolated on the template substrate 7, each of the multiple semi-element portions sDS includes the optical cavity LK (in other words, each of the multiple semi-element portions sDS includes cavity surfaces formed in at least the compound semiconductor layer 9). (ii) The single piece 8V of the base semiconductor layer 8 and the single piece 9V of the compound semiconductor layer 9 included in the semi-element portion sDS are not further divided, and the semi-element portion sDS becomes an element portion (second element portion) DS in a post-step.

Although various forms of the dividing portion PS are illustrated in FIG. 6B, the forms of the dividing portion PS are not limited thereto. As illustrated in FIG. 6B, in the step of element isolation on the template substrate 7, in the thickness direction of the semiconductor substrate 10, the mask portion 5 may be partially or entirely divided, the mask portion 5 need not be divided, or the mask portion 5 and the underlying layer 4 may be divided, by the dividing portion PS. In this step, not all of the main substrate 1 in the thickness direction need be divided. Note that cracks may occur in some portions of the main substrate 1 in the thickness direction.

In the manufacturing method for the laser diode element according to the present embodiment, a specific technique in the step of element isolation on the template substrate 7 is not limited. For example, as described above, the base semiconductor layer 8 may be formed after the mask layer 6 is formed so that the mask portion 5 includes the starting point inducing portion. In this case, the base semiconductor layer 8 can include a starting portion, which is a portion that tends to be a starting point for cleavage. Similarly to the base semiconductor layer 8, the compound semiconductor layer 9 can also include a starting portion for cleavage. The multiple semi-element portions sDS may be formed by causing cleavage from the starting portion due to thermal stress or physical external force. Note that the base semiconductor layer 8 may be cleaved before forming the compound semiconductor layer 9. In this case, after cleaving the base semiconductor layer 8, the compound semiconductor layer 9 may be formed on all of the multiple pieces of the base semiconductor layer 8. The compound semiconductor layer 9 can be isolated into the multiple semi-element portions sDS by cleaving or dividing.

For example, the mask portion 5 does not need to include the starting point inducing portion. In this case, the starting point for cleavage may be formed in the base semiconductor layer 8 or the compound semiconductor layer 9 by scribing or other processing. Cleavage may be caused from the starting point by applying external force to the base semiconductor layer 8 and/or the compound semiconductor layer 9. By scribing the compound semiconductor layer 9, cleavage may spontaneously progress due to internal stresses in the base semiconductor layer 8 and the compound semiconductor layer 9.

For example, the base semiconductor layer 8 or the compound semiconductor layer 9 can be isolated into the multiple semi-element portions sDS by etching. In this case, the dividing portion PS may be a groove (trench) formed by etching.

As described above, the manufacturing method for the laser diode element according to the present embodiment may include the following steps: (i) a step of preparing the main substrate 1, the base semiconductor part 8 formed above the main substrate 1, and the compound semiconductor part 9 formed on the base semiconductor part 8; and (ii) a step of isolating the base semiconductor part 8 and the compound semiconductor part 9 so as to form cavity surfaces at least in the compound semiconductor part 9, and isolating the base semiconductor part 8 and the compound semiconductor part 9 into multiple element portions (e.g., semi-element portions sDS). In the step of multiple-element-portion isolation, on the growth substrate (e.g., on the template substrate 7), the base semiconductor part 8 and the compound semiconductor part 9 may be isolated into the multiple semi-element portions sDS each including cavity surfaces (e.g., the emission surface F1 and the facing surface F2). By isolating the base semiconductor layer 8 and the compound semiconductor layer 9 into the multiple element portions (e.g., semi-element portions sDS), the optical cavity LK including the cavity surfaces (e.g., the emission surface F1 and the facing surface F2) may be formed.

The manufacturing method for the laser diode element according to the present embodiment includes the following steps: (i) a step of preparing the main substrate 1, the base semiconductor part 8 formed above the main substrate 1, and the compound semiconductor part 9 formed on the base semiconductor part 8; and (ii) a step of forming multiple optical cavities LK each including cavity surfaces (e.g., the emission surface F1 and the facing surface F2) by dividing the base semiconductor part 8 and the compound semiconductor part 9. For example, by dividing the base semiconductor layer 8 and the compound semiconductor layer 9 on the growth substrate (e.g., on the template substrate 7), the multiple optical cavities LK each including cavity surfaces may be formed. In the step of forming multiple optical cavities LK, the main substrate 1 need not be divided, or the main substrate 1 may be divided into fewer portions than the multiple optical cavities LK. For example, the main substrate 1 may be divided so that one of multiple pieces formed by dividing the main substrate 1 includes multiple semi-element portions sDS.

According to the manufacturing method for the laser diode element in the present embodiment, the cavity surfaces can be easily formed even when the laser diode element 20 is downsized. Accordingly, the optical cavity LK can be easily formed. Then, by peeling off the element portion DS formed, as described later, from the growth substrate, the laser diode element 20 can be manufactured by mounting the element portion DS on the support substrate. Thus, handling can be improved. A substrate suitable for mounting can be used as the support substrate.

### Step of Forming Element Structure

Then, in the manufacturing method for the laser diode element according to the present embodiment, a step of forming an element structure for the semi-element portion sDS on the template substrate 7 is performed. Thus, the element portion DS is formed. At this stage, the base semiconductor layer 8 included in the element portion DS and the mask portion 5 are bonded by van der Waals force, and the element portion DS may be a part of the semiconductor substrate 10.

In the step of forming an element structure, for example, after forming the ridge portion RJ in the p-type semiconductor layer 9P of the compound semiconductor layer 9, the insulating film DF is formed, and then the first electrode E1 (anode) is formed at a position in contact with the ridge portion RJ. Then, for example, when the laser diode element 20 has a single-sided two-electrode structure, the second electrode E2 may be formed on an upper surface of the base semiconductor layer 8 after exposing a portion of the upper surface of the base semiconductor layer 8 by etching or the like. Thus, the element portion DS can be obtained. By providing the ridge portion RJ and the insulating film DF, in the element portion DS, a current path between the first electrode E1 and the base semiconductor layer 8 is narrowed on an anode side, enabling efficient light emission in the cavity LK. The ridge portion RJ may overlap the second part B2 (low dislocation part) and does not need to overlap the first part B 1, of the base semiconductor part 8 in plan view. The second electrode E2 may overlap the second part B2 (low dislocation part) of the base semiconductor part 8 in plan view. Thus, a current path from the first electrode E1 to the second electrode E2 via the compound semiconductor part 9 and the base semiconductor part 8 is formed in a portion overlapping the second part B2 in plan view (a portion with few threading dislocations), which enhances light emission efficiency in the active layer 9K. This is because the threading dislocations act as non-radiative recombination centers. The second electrode E2 may overlap the second part B2 and the third part B3 (low dislocation parts) of the base semiconductor part 8 in plan view. In this case, electron injection efficiency from the second electrode E2 into the base semiconductor part 8 is enhanced.

When the laser diode element 20 has a double-sided electrode structure, the second electrode E2 may be formed in a post-step. In this specification, an element having an element structure without the second electrode E2 obtained in the step of forming an element structure is also referred to as the element portion DS.

### Step of Mounting Element Portion

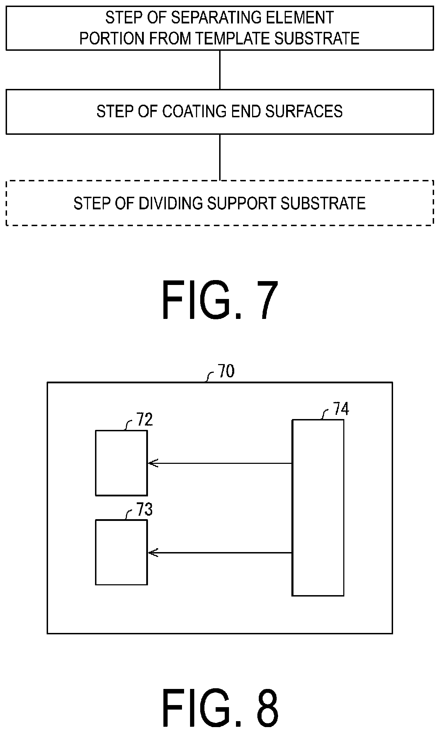

FIG. 7 is a flowchart illustrating an example of a mounting stage in the manufacturing method for the laser diode element according to the present embodiment.

As illustrated in FIG. 7, first, a step of separating the element portion DS from the template substrate 7 is performed. For example, after bonding the first electrode E1 to a pad of a support substrate, the element portion DS may be separated from the template substrate 7 using the support substrate. Thereafter, the laser diode element 20 may be formed in a step of coating the end surfaces of the optical cavity LK included in the element portion DS. The laser diode element 20 may be formed by dividing the support substrate on which the element portion DS is mounted. The support substrate may function as a submount. Thus, a chip with the laser diode element 20 mounted on the divided support substrate can be formed. A specific example of the support substrate will be described later.

According to the manufacturing method for the laser diode element 20 in the present embodiment, the template substrate 7 or the underlying substrate UK can also be reused. The laser diode element 20 can be formed by transferring the element portion DS from a substrate unsuitable for mounting to a substrate suitable for mounting (support substrate).

### Manufacturing Apparatus

FIG. 8 is a block diagram illustrating an example of a manufacturing apparatus. As illustrated in FIG. 8, a manufacturing apparatus 70 includes a semiconductor layer forming unit 72 that forms the base semiconductor layer 8 and the compound semiconductor layer 9 on the template substrate 7, a processing unit 73 that forms the element structure, and a controller 74 that controls the semiconductor layer forming unit 72 and the processing unit 73.

The semiconductor layer forming unit 72 may include, for example, an MOCVD (metal-organic chemical vapor deposition) system that forms the base semiconductor layer 8 using the ELO method, and forms the compound semiconductor layer 9 on the base semiconductor layer 8. When an object to be processed is taken out from a processing system (deposition system) such as an MOCVD system, a step of element isolation may be performed. The semiconductor layer forming unit 72 may be controlled so that after forming the base semiconductor layer 8, the object to be processed is once taken out from the processing system, and then the object to be processed is again fed into the processing system to form the compound semiconductor layer 9 on the base semiconductor layer 8. The semiconductor layer forming unit 72 may have a function of manufacturing the template substrate 7.

The processing unit 73 may form the semi-element portions sDS in the step of element isolation. The processing unit 73 performs various processes on the semi-element portion sDS located on the template substrate 7 to form the element portion DS. The processing unit 73 may perform a step of separating the element portion DS from the template substrate 7 using the support substrate, and may perform a step of coating the end surfaces of the optical cavity LK.

The controller 74 may include a processor and a memory. The controller 74 may control the semiconductor layer forming unit 72 and the processing unit 73 by executing a program stored in, for example, a built-in memory or a communicable communication device, or on an accessible network. The program and a recording medium or the like in which the program is stored are also included in the present embodiment.

### Other Embodiments

(a) In a manufacturing method for the laser diode element 20 according to another embodiment of the present disclosure, a GaN substrate may be used as a growth substrate instead of the underlying substrate UK. In this case, the main substrate 1 may be the GaN substrate. That is, the main substrate 1 may be a growth substrate. A semiconductor substrate in which a semiconductor layer containing a nitride semiconductor (the above-described GE semiconductor layer) is formed on the GaN substrate without forming the mask layer 6 can also be used.
   For example, by removing some portions of the GE semiconductor layer in the semiconductor substrate by etching, multiple island-shaped semiconductor layers having a shape as illustrated in FIG. 5 can be formed. Then, after forming a compound semiconductor layer on the semiconductor layer, a step of element isolation is performed to form multiple semi-element portions sDS.
(b) A manufacturing method for the laser diode element 20 according to still another embodiment of the present disclosure is not limited to using the template substrate 7 in which the seed layer 3 overlaps the entire mask portion 5. Since the seed layer 3 only needs to be exposed through the opening portion KS, the template substrate 7 in which the seed layer 3 is locally formed so as not to overlap part or all of the mask portion 5 may be used. For example, the buffer layer 2 may be located on the main substrate 1, and the seed layer 3 may be locally provided on the buffer layer 2 so as to overlap the opening portion KS of the mask layer 6.
(c) In a manufacturing method for the laser diode element 20 according to yet another embodiment of the present disclosure, the underlying substrate UK in which the buffer layer 2 is not provided between the main substrate 1 and the seed layer 3 may be used as a growth substrate. That is, the template substrate 7 including the underlying substrate UK including the main substrate 1 and the seed layer 3 and the mask layer 6 formed on the underlying substrate UK may be used. The template substrate 7 can be formed without the buffer layer 2 when using the main substrate 1 made of a material that does not melt together with the seed layer 3 or when using the seed layer 3 made of a material that has low reactivity with the main substrate 1. Thus, a deposition process of the buffer layer 2 is omitted, thereby reducing costs of the deposition process.

For example, the seed layer 3 may be made of a material that has low reactivity with the main substrate 1 and can serve as a growth starting point for the base semiconductor layer 8. The seed layer 3 may be, for example, an AlN layer or a SiC layer, or may be a layer containing AlN and/or SiC.

(d) A laser diode element 20 according to a further embodiment of the present disclosure may include the base semiconductor layer 8 that does not include the first part B 1, that is, the base semiconductor layer 8 that includes one second part B2. For example, before the element portion DS is separated from the template substrate 7, the first part B 1 may be removed by etching or the like.

### Example 1

Hereinafter, manufacturing methods and the like for the semiconductor device of the present disclosure will be described in more detail with reference to examples. However, the present disclosure is not limited to configurations described below, and various changes can be made within the scope of the claims. In the following, configurations of the multiple examples of the present disclosure will be described with the same reference signs for the same or equivalent portions in the figures. However, unless otherwise specified, embodiments obtained by appropriately combining technical means disclosed in the above-described embodiments and the multiple different examples described below are also included in the technical scope of the present disclosure.

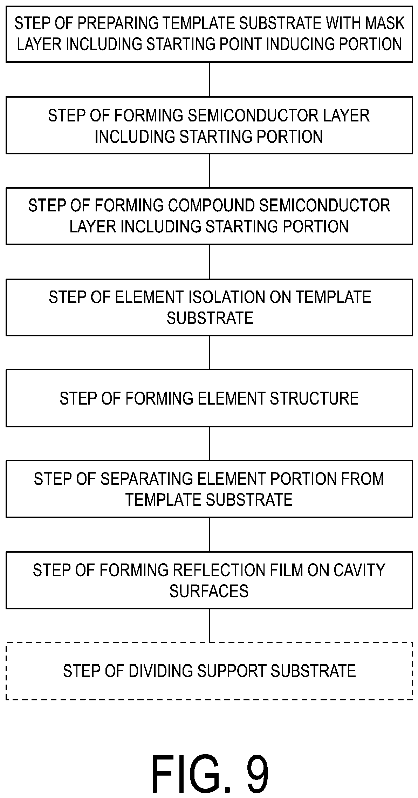

FIG. 9 is a flowchart illustrating an example of a manufacturing method for the laser diode element 20 in Example 1. In Example 1, the mask layer 6 of the template substrate 7 includes the mask portion 5 including a starting point inducing portion. Then, an ELO semiconductor layer including a starting portion is formed on the template substrate 7. As illustrated in FIG. 9, in Example 1, first, the template substrate 7 including the starting point inducing portion in the mask layer 6 is prepared, and then the semiconductor layers (the base semiconductor layer 8 and the compound semiconductor layer 9) including the starting portions are formed on the template substrate 7.

### Step of Preparing Template Substrate

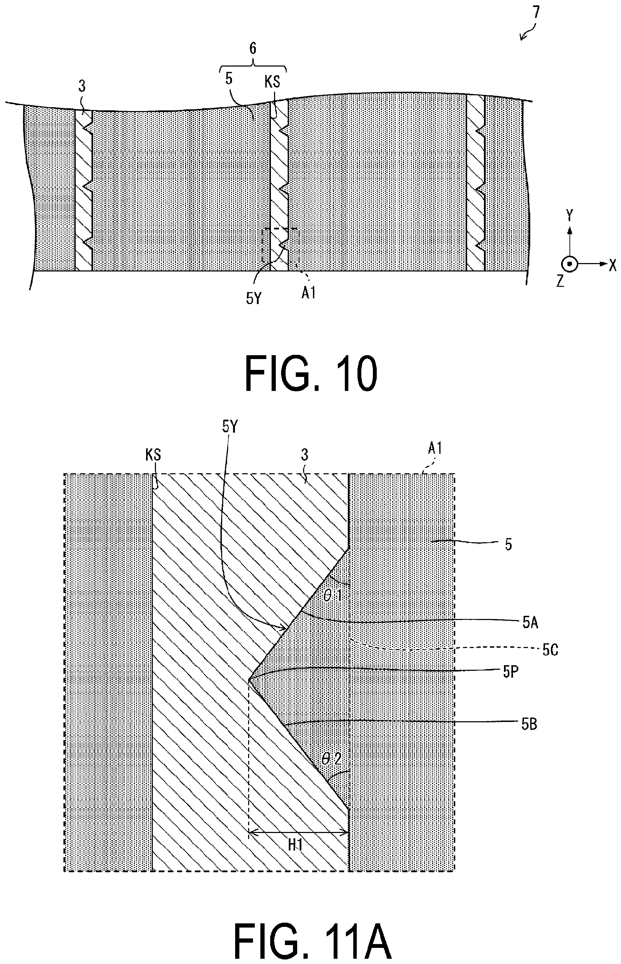

FIG. 10 is a cross-sectional view illustrating a configuration of the template substrate 7 in Example 1. FIG. 11A is an enlarged view of a main portion in FIG. 10. A heterogeneous substrate having a different lattice constant from that of a nitride semiconductor may be used as the main substrate 1 in the template substrate 7. By using a Si substrate as the main substrate 1, manufacturing costs of the template substrate 7 can be reduced. As a result, manufacturing costs of the laser diode element 20 can be reduced. The main substrate 1 may be an Al₂O₃ substrate or a SiC substrate, which may reduce reactivity with Ga. The main substrate 1 may be made of any material and have any plane orientation as long as the ELO semiconductor layer can be grown, and the material and the plane orientation of the main substrate 1 are not limited.

In Example 1, the underlying substrate UK may be manufactured by forming the underlying layer 4 (see FIG. 4) on the main substrate 1, or the underlying substrate UK prepared in advance may be used. By using the underlying substrate UK prepared in advance, the base semiconductor layer 8 and the like can be easily and stably grown. This is because, when performing a process of depositing the underlying layer 4, this process may affect the base semiconductor layer 8 and the like.

The template substrate 7 may include, for example, the seed layer 3 as the underlying layer 4. The seed layer 3 is a layer that serves as a growth starting point for the base semiconductor layer 8 when depositing the base semiconductor layer 8. The seed layer 3 may contain a GaN-based semiconductor, aluminum nitride (AlN), SiC, graphene, or the like. Silicon carbide used for the seed layer 3 may be 6H-SiC or 4H-SiC in a hexagonal system. The seed layer 3 may be, for example, an AlGaN layer or may be a graded layer in which Al composition gradually increases so as to approach GaN. The seed layer 3 may include a GaN layer. In this case, the seed layer 3 may be a GaN single layer, or the uppermost layer of the graded layer as the seed layer 3 may be a GaN layer. The seed layer 3 may be made of any material and have any plane orientation as long as the base semiconductor layer 8 containing a nitride semiconductor can be grown.

The template substrate 7 may include the buffer layer 2 (see FIG. 4) located between the main substrate 1 and the seed layer 3 as the underlying layer 4. For example, when a silicon substrate is used for the main substrate 1 and a GaN-based semiconductor is used for the seed layer 3, the buffer layer 2 provided between the silicon substrate and the GaN-based semiconductor can reduce melting of the silicon substrate and the GaN-based semiconductor with each other. The buffer layer 2 may have an effect of increasing the crystallinity of the seed layer 3 and/or an effect of relieving internal stress of the seed layer 3.

The buffer layer 2 may typically be an AlN layer or may be a SiC layer. The SiC used for the buffer layer 2 may be a hexagonal system (6H-SiC, 4H-SiC) or a cubic system (3C-SiC). The buffer layer 2 may be a multilayer film including an AlN film and/or a SiC film. The buffer layer 2 may include a strain relief layer. Examples of the strain relief layer include an AlGaN superlattice structure and a graded structure in which the Al composition of AlGaN is changed stepwise. The stress of the base semiconductor layer 8 in the longitudinal direction can be relieved by the strain relief layer. The AlN layer being an example of the buffer layer 2 can be formed using an MOCVD system, for example, to have a thickness of from about 10 nm to about 5 µm.

The underlying layer 4 can be formed by layering various layers on the main substrate 1 using an MOCVD system, a sputtering system, or the like. For example, the buffer layer 2 (e.g., aluminum nitride) and/or the seed layer 3 (e.g., GaN-based semiconductor) may be deposited on the main substrate 1 using a sputtering system (PSD: pulse sputter deposition, PLD: pulse laser deposition, etc.). Thus, the underlying substrate UK can be manufactured.

The template substrate 7 is manufactured by forming the mask layer 6 on the underlying substrate UK. As the mask layer 6, for example, a single-layer film including any one of a silicon oxide film (SiOx), a titanium nitride film (TiN, etc.), a silicon nitride film (SiNx), a silicon oxynitride film (SiON), and a metal film having a high melting point (e.g., 1000°C or higher), or a laminate film including at least two thereof may be used.

In Example 1, the mask layer 6 is formed on the underlying substrate UK so that a starting point inducing portion 5Y is provided in a portion of the mask portion 5. The starting point inducing portion 5Y in Example 1 has a triangular shape in plan view. The starting point inducing portion 5Y has an apex 5P and two sides 5A and 5B connected at the apex 5P in plan view. In plan view, a virtual line segment connecting an end of the side 5A and an end of the side 5B on a side opposite to the apex 5P is referred to as a side 5C. A virtual triangle is formed by the side 5A, the side 5B, and the side 5C. The side 5C can be said to be a base of the virtual triangle. An angle formed by the side 5A and the side 5B is referred to as θ1, and an angle formed by the side 5B and the side 5C is referred to as θ2. A distance from the side 5C to the apex 5P is referred to as a protrusion length H1 of the starting point inducing portion 5Y.

The starting point inducing portion 5Y may have the same thickness as the rest of the mask portion 5. The angle θ1 may be 30° or substantially 30°, for example, about 20° to 40°. In this specification, "substantially" means within a variation range of ±10%. The angle θ1 and the angle θ2 may be the same or may be substantially the same. The side 5A may have a length of about, for example, 0.1 µm to 20 µm. The side 5A and the side 5B may have the same length or substantially the same length. In this specification, "substantially the same" means that a difference is within a range of 10% based on the larger numerical value. The protrusion length H1 of the starting point inducing portion 5Y may be, for example, about 0.1 µm to 10 µm.

The specific shape of the starting point inducing portion 5Y is not limited as long as the starting point inducing portion 5Y can form a starting point for cleavage in the base semiconductor layer 8, as described later. The starting point inducing portion 5Y is not limited to a shape in which a tip of the apex 5P is sharp in plan view, and the apex 5P may have a rounded shape. In the starting point inducing portion 5Y, the angle θ1 and the angle θ2 may be different from each other. The starting point inducing portion 5Y may have a quadrilateral shape in plan view, or may have any other shape. A portion of the mask portion 5 other than the starting point inducing portion 5Y is referred to as a main portion. The starting point inducing portion 5Y and the main portion may have different thicknesses from each other. The starting point inducing portion 5Y and the main portion may be formed integrally, or the starting point inducing portion 5Y may be formed after forming the main portion.

The opening portion KS has a longitudinal shape except for a portion where the starting point inducing portion 5Y is provided, and has a relatively narrow width at the portion where the starting point inducing portion 5Y is provided. In Example 1, by providing the starting point inducing portion 5Y, the mask layer 6 is formed so as to include a notch in the opening portion KS. The multiple opening portions KS may be periodically arranged with a first period in the X direction. The width of the opening portion KS may be about 0.1 µm to 20 µm. The narrower the width of the opening portion KS, the smaller the number of threading dislocations that propagate through the opening portion KS to the base semiconductor layer 8. The base semiconductor layer 8 may be easily peeled off in a post-step. The area of the second part B2 with fewer surface defects may be increased.

In Example 1, the mask layer 6 including the mask portion 5 may be formed, for example, as follows. First, a silicon oxide film having a thickness of about 100 nm to about 4 µm (preferably about 150 nm to about 2 µm) is formed on an entire surface of the underlying layer 4 by sputtering. Then, a resist is applied to an entire surface of the silicon oxide film. Thereafter, the resist is patterned by photolithography to form the resist having a plurality of stripe-shaped opening portions. At this time, in Example 1, the resist at the position corresponding to the starting point inducing portion 5Y is not removed. Thereafter, by removing the silicon oxide film at several portions using a wet etchant such as hydrofluoric acid (HF) or buffered hydrofluoric acid (BHF), the multiple opening portions KS and the multiple mask portions 5 including the starting point inducing portions 5Y are formed. Subsequently, the resist is removed by organic cleaning to form the mask layer 6.

Note that in the mask layer 6, for example, in one mask portion 5, protruding directions of the multiple starting point inducing portions 5Y, in other words, directions of the multiple notches in the opening portion KS may be aligned in one direction. Accordingly, as will be described later, in the laser diode element 20 manufactured using the template substrate 7, of the second part B2 and the third part B3, a pair of cavity surfaces (the emission surface F1 and the facing surface F2) can be formed, for example, in the second part B2 (see FIG. 1, etc.) located farther from the starting point inducing portion 5Y. The second part B2 is less likely to be affected by the starting point inducing portion 5Y. As a result, the likelihood of the quality of the pair of cavity surfaces deteriorating can be reduced. However, it is needless to say that the mask layer 6 can be formed by appropriately changing the orientation of the starting point inducing portion 5Y.

### Shape Examples of Starting Point Inducing Portion

Other specific examples of the shape of the starting point inducing portion 5Y will be described below.

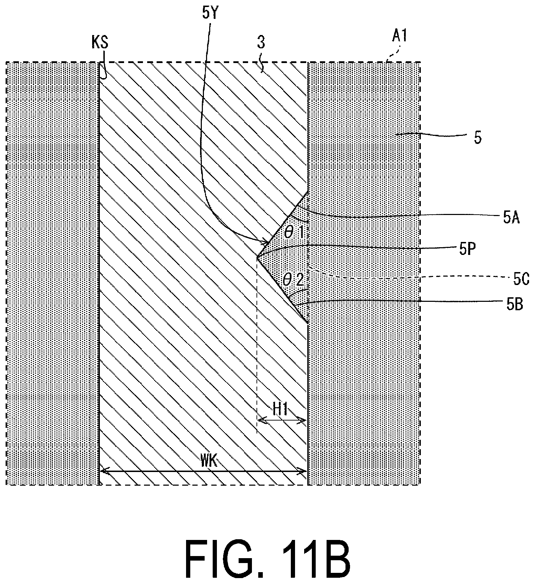

FIG. 11B is a plan view illustrating an example of the starting point inducing portion 5Y. As illustrated in FIG. 11B, the starting point inducing portion 5Y as the example may have a shape in which the apex 5P is not located beyond the center of the opening portion KS. That is, the protrusion length H1 of the starting point inducing portion 5Y may be, for example, 0.1 µm or more and less than WK/2 (WK: the width of the opening portion KS). The starting point inducing portion 5Y may have, for example, an isosceles triangular shape or an equilateral triangular shape in plan view.

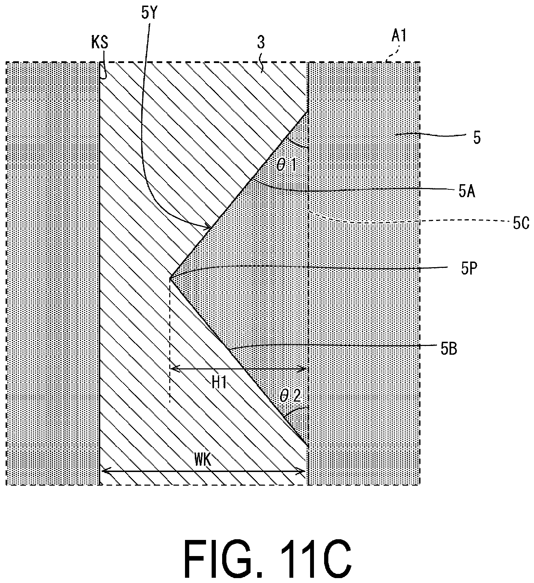

FIG. 11C is a plan view illustrating another example of the starting point inducing portion 5Y. As illustrated in FIG. 11C, the starting point inducing portion 5Y as the other example may have a shape in which the apex 5P is located beyond the center of the opening portion KS. That is, the protrusion length H1 of the starting point inducing portion 5Y may be, for example, WK/2 or more and less than WK. Further, for example, the angle θ1 and the angle θ2 may exceed 40°.

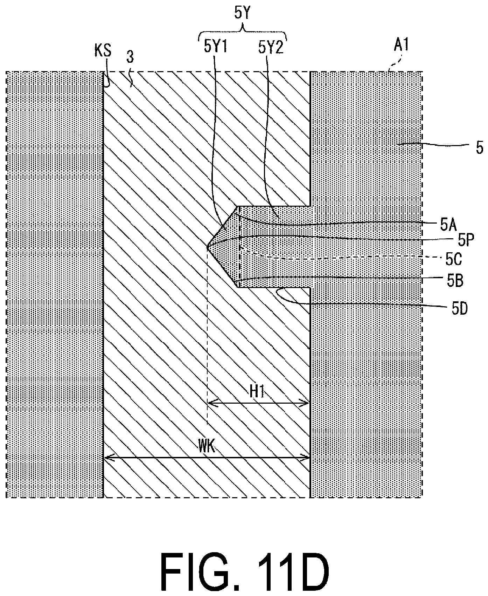

FIG. 11D is a plan view illustrating still another example of the starting point inducing portion 5Y. As illustrated in FIG. 11D, the starting point inducing portion 5Y as the still another example may have a virtual pentagonal shape in plan view, which is a combination of a virtual triangle 5Y1 and a virtual quadrilateral 5Y2. The virtual quadrilateral 5Y2 may have a square shape or a rectangular shape. In the virtual quadrilateral 5Y2, the length of a virtual side 5D having a length direction, which is the width direction of the opening portion KS, may be, for example, about 0.1 µm to 10 µm. The side 5D may be a line segment extending parallel or substantially parallel to the width direction of the opening portion KS. The virtual quadrilateral 5Y2 may have, for example, a trapezoidal shape. The apex 5P of the virtual triangle 5Y1 may be located at a position beyond the center of the opening portion KS or may be located at a position not beyond the center of the opening portion KS.

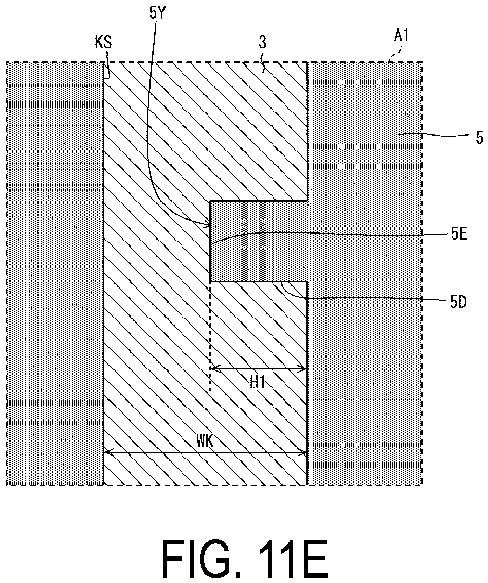

FIG. 11E is a plan view illustrating yet another example of the starting point inducing portion 5Y. As illustrated in FIG. 11E, the starting point inducing portion 5Y as the yet another example may have a quadrilateral shape in plan view. In this case, the starting point inducing portion 5Y does not have the apex 5P, and a distance between a side 5E having a length direction, which is the longitudinal direction of the opening portion KS, and the main portion of the mask portion 5 is defined as the protrusion length H1. The side 5E may have a length of, for example, about 0.1 µm to 10 µm. The starting point inducing portion 5Y may have, for example, a trapezoidal shape or a parallelogram shape in plan view. The side 5E may be located at a position beyond the center of the opening portion KS or may be located at a position not beyond the center of the opening portion KS. That is, the length of the side 5D may be, for example, about 0.1 µm to 20 µm.

### Step of Forming Semiconductor Layer

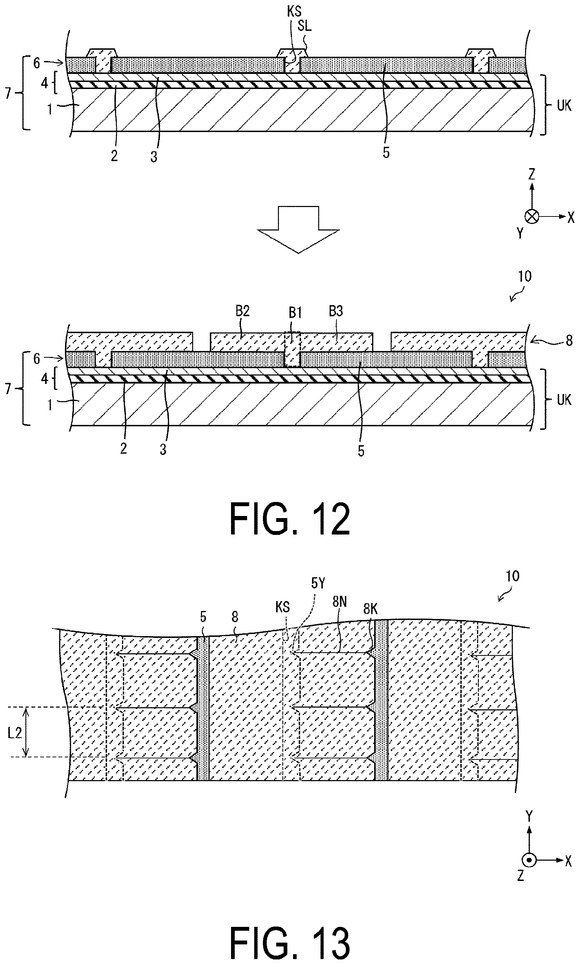

Subsequently, the base semiconductor layer 8 is deposited on the template substrate 7. In Example 1, for example, the template substrate 7 is placed in an MOCVD system, and the GaN-based semiconductor layer is deposited by the ELO method. FIG. 12 illustrates cross-sectional views of an example of lateral growth of the base semiconductor layer 8 in Example 1. The base semiconductor layer 8 in Example 1 is a nitride semiconductor (e.g., a GaN-based semiconductor layer) and is obtained by c-plane deposition on the template substrate 7. The base semiconductor layer 8 may be an n-type semiconductor layer containing a donor. In FIG. 12 and other figures, the [-1100] direction of the GaN-based semiconductor is the positive direction of the Y-axis, the [11-20] direction of the GaN-based semiconductor is the positive direction of the X-axis, and the [0001] direction of the GaN-based semiconductor is the positive direction of the Z-axis (thickness direction).

As illustrated in FIG. 12, in the ELO method, an initial growth layer SL is formed on the seed layer 3, and then the base semiconductor layer 8 can be grown laterally from the initial growth layer SL. The initial growth layer SL is a starting point of the lateral growth of the base semiconductor layer 8, and is part of the first part B 1. By appropriately controlling the ELO deposition conditions, the base semiconductor layer 8 can be controlled to grow in the Z direction (c-axis direction) or in the X direction (a-axis direction).

Here, the ELO deposition conditions may be controlled so that the deposition of the initial growth layer SL is stopped just before an edge of the initial growth layer SL rides up to an upper surface of the mask portion 5 (when the edge is in contact with an upper end of a side surface of the mask portion 5) or just after the edge of the initial growth layer SL rides up to the upper surface of the mask portion 5 (i.e., at this timing, the ELO deposition conditions are switched from the c-axis deposition conditions to the a-axis deposition conditions). In this way, lateral deposition is performed from a state where the initial growth layer SL protrudes slightly from the mask portion 5, so that the material is less likely to be consumed for growth of the base semiconductor layer 8 in the thickness direction and the base semiconductor layer 8 can be grown laterally at a high speed. The initial growth layer SL may be formed to have a thickness of, for example, 2.0 µm or more and 3.0 µm or less.

In Example 1, the base semiconductor layer 8 was an n-type GaN layer, and the ELO deposition of Si-doped GaN was performed on the template substrate 7 using the MOCVD system. The following may be adopted as examples of the ELO deposition conditions: substrate temperature: 1120°C, growth pressure: 50 kPa, TMG (trimethylgallium): 22 sccm, NH₃: 15 slm, and V/III = 6000 (ratio of group V raw material supply amount to group III raw material supply amount). The initial growth layer SL was selectively grown on the seed layer 3 (the GaN layer that is the uppermost layer of the seed layer 3) exposed through the opening portion KS, and subsequently laterally grown on the mask portion 5. The lateral growth was stopped before the base semiconductor layers 8, which grew laterally from both sides on the mask portion 5, came into contact with each other.

In Example 1, by including the starting point inducing portion 5Y in the mask layer 6, a disturbance may occur in the lateral growth of the base semiconductor layer 8 at the portion where the starting point inducing portion 5Y is present. FIG. 13 is a plan view for explaining the base semiconductor layer 8 in Example 1.

As illustrated in FIG. 13, in Example 1, the base semiconductor layer 8 includes a starting portion 8K that serves as a starting point for cleavage. The starting portion 8K is spontaneously formed in the base semiconductor layer 8 by growing the base semiconductor layer 8 from the opening portion KS including the notch. Note that the relationship between the shape of the starting point inducing portion 5Y and a shape of the starting portion 8K may change depending on the growth conditions of the base semiconductor layer 8. The starting portion 8K may be smaller or larger than the shape of the starting point inducing portion 5Y, or may be substantially the same as the shape of the starting point inducing portion 5Y. An example of the starting portion 8K will be described below.

For example, the base semiconductor layer 8 may include an oblique contact portion 8N extending from the position of the starting point inducing portion 5Y of the mask layer 6 to the position of the starting portion 8K of the base semiconductor layer 8 in plan view. The oblique contact portion 8N is a portion where semiconductor layers grown obliquely with respect to the X direction (a-axis direction) come into contact with each other. The oblique contact portion 8N may be, for example, a crystal grain boundary, or may be a portion in which the crystal structure is more disordered (i.e., there are more lattice defects) than in other portions of the base semiconductor layer 8. In FIG. 13, the oblique contact portion 8N is illustrated by a solid line. When the base semiconductor layer 8 includes the oblique contact portion 8N, the oblique contact portion 8N can be observed, for example, by CL-measurement.

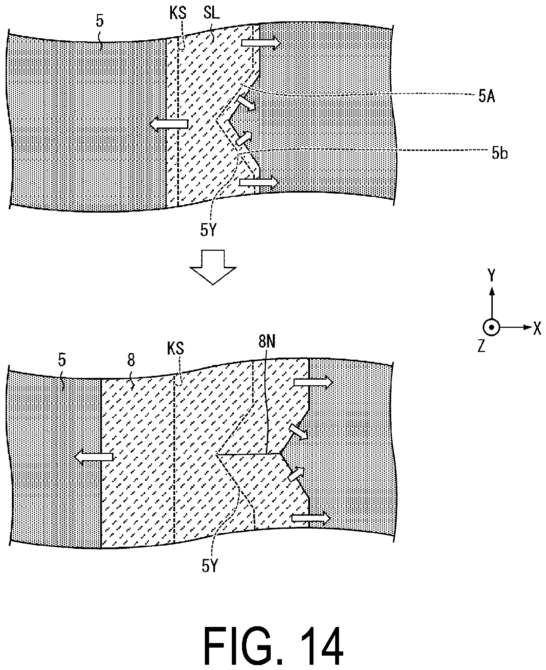

FIG. 14 illustrates enlarged views for explaining how the base semiconductor layer 8 grows around the starting point inducing portion 5Y in Example 1. As illustrated in FIG. 14, first, the initial growth layer SL is formed through the opening portion KS. At this time, in portions of the opening portion KS other than the area around the starting point inducing portion 5Y, the initial growth layer SL is formed so as to rise up to the upper surface of the mask portion 5 by the lateral growth of the GaN-based semiconductor in the <11-20> direction (i.e., the a-axis direction). On the other hand, in the area around the starting point inducing portion 5Y in the opening portion KS, the presence of the starting point inducing portion 5Y may cause a notch at a portion of the initial growth layer SL that has grown through the opening portion KS to ride up to the upper surface of the mask portion 5. For example, in plan view, a direction orthogonal to the side 5A of the starting point inducing portion 5Y may be an m-plane direction of the GaN-based semiconductor (e.g., a [10-10] direction), and a direction orthogonal to the side 5B may be another m-plane direction of the GaN-based semiconductor (e.g., a [01-10] direction). A growth rate in the m-plane direction of the GaN-based semiconductor is smaller than a growth rate in the a-plane direction. The base semiconductor layer 8 can grow so as to maintain the notch formed in the initial growth layer SL.

The oblique contact portion 8N can be generated, for example, when the semiconductor layer grown in the [10-10] direction and the semiconductor layer grown in the [01-10] direction come into contact with each other. The oblique contact portion 8N can also exist on the surface of the base semiconductor layer 8 by affecting (propagating) to the surface of the base semiconductor layer 8 after deposition after the oblique contact portion 8N is generated in the vicinity of the mask portion 5. The starting portion 8K may have a tapered shape such as a triangular shape in plan view. Thus, stress tends to concentrate at one point during cleavage. As a result, a good cleavage plane can be easily obtained. The starting portion 8K may include end surfaces that are m-planes of the GaN-based semiconductor. Note that the end surfaces of the starting portion 8K do not need to be the m-planes of the GaN-based semiconductor.

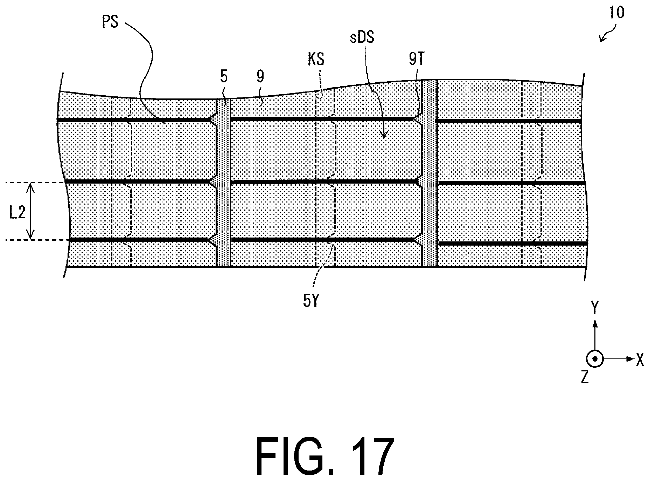

When a distance between the multiple starting portions 8K in the base semiconductor layer 8 (a distance between tips of two starting portions 8K) is L2 (see FIG. 17), the distance L2 corresponds to the cavity length L1 (see FIG. 2). The distance L2 may be about 20 µm to 200 µm. When the distance L2 is short, the number of locations where internal stresses are released due to cleavage increases. Accordingly, during cleavage when cooling, which will be described later, the likelihood of element isolation at unintended locations can be reduced. The distance L2 may be 300 µm or more. When the distance L2 is increased, the likelihood of there being the starting portions 8K that do not cause cleavage during cooling, which will be described later, can be reduced, so that the yield when manufacturing the semiconductor device can be improved.

In the deposition of the base semiconductor layer 8, it is preferable that interaction between the base semiconductor layer 8 and the mask portion 5 be reduced, and contact between the base semiconductor layer 8 and the mask portion 5 due to van der Waals force be maintained. That is, the base semiconductor layer 8 and the mask portion 5 may be in contact with each other mainly by van der Waals force.

### Step of Forming Compound Semiconductor Layer

In Example 1, after manufacturing the semiconductor substrate 10 in which the base semiconductor layer 8 is formed on the template substrate 7 using the MOCVD system, the compound semiconductor layer 9 is formed on the base semiconductor layer 8 using the MOCVD system without temporarily taking out the semiconductor substrate 10 from the MOCVD system. The deposition process of the laminate structure, which is the compound semiconductor layer 9, is continuously performed using the MOCVD system without being taken out from the MOCVD system during formation of the laminate structure. The compound semiconductor layer 9 includes a nitride semiconductor layer (e.g., a GaN-based semiconductor layer).

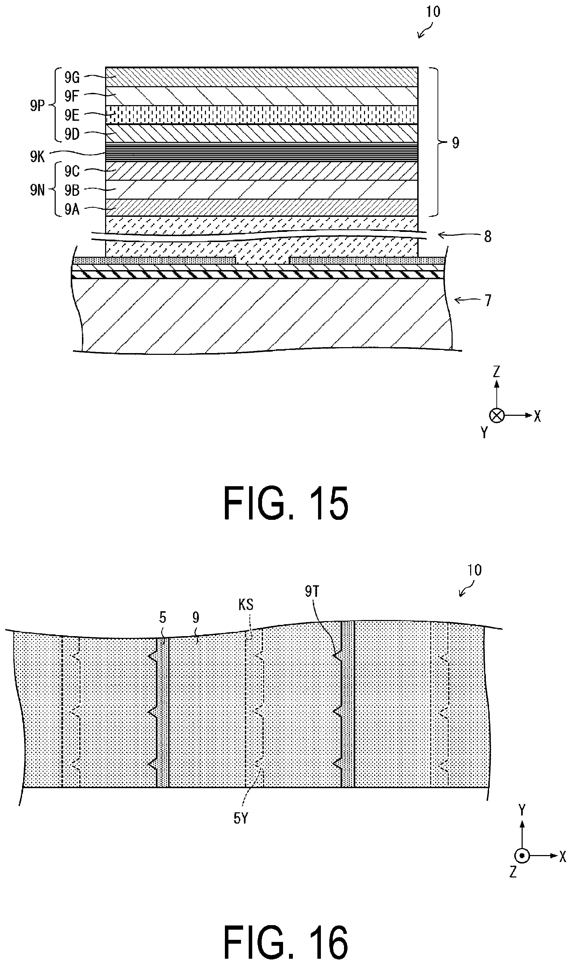

FIG. 15 is a cross-sectional view illustrating a configuration of the compound semiconductor layer 9 in Example 1. As illustrated in FIG. 15, the compound semiconductor layer 9 includes the n-type semiconductor layer 9N containing a donor, the active layer 9K, and the p-type semiconductor layer 9P containing an acceptor, which are formed in this order. The n-type semiconductor layer 9N includes a first contact layer 9A, a first cladding layer 9B, and a first optical guiding layer 9C, which are formed in this order. The p-type semiconductor layer 9P includes a second optical guiding layer 9D, an electron blocking layer 9E, a second cladding layer 9F, and a second contact layer 9G, which are formed in this order. Note that in the p-type semiconductor layer 9P of the compound semiconductor part 9, the second optical guiding layer 9D and the electron blocking layer 9E may be exchanged with each other. For example, the p-type semiconductor layer 9P may include the electron blocking layer 9E, the second optical guiding layer 9D, the second cladding layer 9F, and the second contact layer 9G, which are formed in this order.

For example, an n-type GaN layer can be used for the first contact layer 9A, and, for example, an n-type AlGaN layer can be used for the first cladding layer 9B. The first cladding layer 9B may be an n-type GaN-based semiconductor layer, an n-type AlGaN-based semiconductor layer, or an n-type AlInGaN-based semiconductor layer, and may have a layer thickness of, for example, about 0.8 µm to 2 µm. When GaN or the like not containing Al is used for the first cladding layer 9B, deposition of the GaN-based semiconductor on the surface of the mask portion 5 can be suppressed, thereby improving the yield during peeling (during the step of separating the element portion DS from the template substrate 7, which will be described later). The first optical guiding layer 9C may be, for example, an n-type GaN layer, or an InGaN layer having an In composition of about 3 to 10%. The first optical guiding layer 9C may have a thickness of about 50 nm.

For example, a multi-quantum well (MQW) structure including an InGaN layer can be used for the active layer 9K. The active layer 9K may typically have a structure of 5 to 6 periods. The composition of In varies with the desired emission wavelength. For example, for blue emission (wavelength around 450 nm), the In concentration may be about 15% to 20%. For green emission (wavelength around 530 nm), the In concentration may be about 30%.

For example, a p-type AlGaN layer can be used for the second optical guiding layer 9D. The second optical guiding layer 9D may have an Al composition of about 15% to 25%, for example, and may have a layer thickness of, about 5 nm to 25 nm, for example. The electron blocking layer 9E may be, for example, a p-type GaN layer, or an InGaN layer having an In composition of about 3% to 10%. The electron blocking layer 9E may have a thickness of about 50 nm. For example, a p-type AlGaN layer may be used for the second cladding layer 9F. The second cladding layer 9F may be a p-type GaN-based semiconductor layer, a p-type AlGaN-based semiconductor layer, or a p-type AlInGaN-based semiconductor layer, and may have a layer thickness of, for example, about 0.1 µm to 1 µm. For example, a p-type GaN layer may be used for the second contact layer 9G. The second contact layer 9G may have a layer thickness of, for example, about 0.1 µm to 0.3 µm. Although not illustrated, a highly doped layer containing Mg as a dopant and having a layer thickness of about 10 nm may be formed on a surface of the second contact layer 9G.

The thicknesses of the layers of the compound semiconductor layer 9 can be as follows: the base semiconductor layer 8 > the first cladding layer 9B > the first optical guiding layer 9C > the active layer 9K, and the base semiconductor layer 8 > the second cladding layer 9F > the second optical guiding layer 9D > the active layer 9K. Refraction indices of the layers of the compound semiconductor layer 9 (the refraction index of light generated in the active layer 9K) can be as follows: the first cladding layer 9B < the first optical guiding layer 9C < the active layer 9K, and the insulating film DF < the second cladding layer 9F < the second optical guiding layer 9D < the active layer 9K.

FIG. 16 is a plan view for explaining the compound semiconductor layer 9 in Example 1. As illustrated in FIG. 16, the compound semiconductor layer 9 is formed into a shape including a starting portion 9T corresponding to the starting portion 8K of the base semiconductor layer 8. This is because the compound semiconductor layer 9 is difficult to be formed at a position corresponding to the starting portion 8K of the base semiconductor layer 8. The starting portion 9T may include end surfaces that are m-planes of the GaN-based semiconductor by being formed in a shape corresponding to the starting portion 8K. Note that the end surfaces of the starting portion 9T do not need to be the m-planes of the GaN-based semiconductor.

The above-described steps can be summarized as follows. That is, in Example 1, first, the step of preparing the main substrate 1, the base semiconductor layer 8 formed above the main substrate 1, and the compound semiconductor layer 9 formed on the base semiconductor layer 8 is performed. The notch is formed in the opening portion KS of the mask layer 6. Thus, the starting portion 8K is formed spontaneously in the base semiconductor layer 8. Then, the compound semiconductor layer 9 is formed on the base semiconductor layer 8 including the starting portion 8K. Thus, the starting portion 9T is formed spontaneously in the compound semiconductor layer 9.

### Step of Element Isolation on Template Substrate

Subsequently, by cooling the semiconductor substrate 10 in which the compound semiconductor layer 9 is formed, the base semiconductor layer 8 and the compound semiconductor layer 9 are isolated into multiple semi-element portions sDS on the template substrate 7. FIG. 17 is a plan view for explaining an example of the step of element isolation in Example 1.

The deposition of the compound semiconductor layer 9 may be performed under high temperature conditions using the MOCVD system. In this case, there is a step of cooling in the MOCVD system.

In Example 1, thermal expansion coefficients of the base semiconductor layer 8 and the compound semiconductor layer 9 may be different from a thermal expansion coefficient of the main substrate 1. In this case, internal stress is generated in the base semiconductor layer 8 and the compound semiconductor layer 9 due to a difference in thermal expansion coefficient between both the base semiconductor layer 8 and the compound semiconductor layer 9 and the main substrate 1.

In Example 1, the main substrate 1 and the base semiconductor layer 8 may have different lattice constants from each other. In this case, internal stress is generated in the base semiconductor layer 8 due to a difference in lattice constant between the main substrate 1 and the base semiconductor layer 8. Internal stress may also occur in the compound semiconductor layer 9 under the influence of the internal stress in the base semiconductor layer 8. By using a heterogeneous substrate different from the GaN-based semiconductor (e.g., a Si substrate) for the main substrate 1, internal stress can be easily generated in the base semiconductor layer 8 and the compound semiconductor layer 9.

As illustrated in FIG. 17, when the semiconductor substrate 10 is cooled, the internal stress in the base semiconductor layer 8 and the compound semiconductor layer 9 may cause the base semiconductor layer 8 and the compound semiconductor layer 9 to be cleaved from the starting portion 8K and the starting portion 9T having the notch shapes as the starting points to form the dividing portion PS. That is, in Example 1, cleavage may occur spontaneously during cooling of the base semiconductor layer 8 and the compound semiconductor layer 9.

The base semiconductor layer 8 and the compound semiconductor layer 9 may each include the starting portion 8K and the starting portion 9T including the tapered notches. In this case, since stress tends to concentrate at one point, a high-quality cleavage plane can be easily generated by cleavage. The shapes of the starting portion 8K and the starting portion 9T are influenced by the shape of the starting point inducing portion 5Y of the mask portion 5 in the mask layer 6. The shape of the starting point inducing portion 5Y may affect the quality of the cleavage plane.

Tensile stress may be generated in the base semiconductor layer 8 as internal stress. For example, when the thermal expansion coefficient of the main substrate 1 is larger than the thermal expansion coefficient of the base semiconductor layer 8, compressive stress is generated in the base semiconductor layer 8, and when the thermal expansion coefficient of the main substrate 1 is smaller than the thermal expansion coefficient of the base semiconductor layer 8, tensile stress is generated in the base semiconductor layer 8. When cleaving the base semiconductor layer 8 under the tensile stress, the likelihood of divided pieces of the base semiconductor layer 8 coming into contact with each other can be reduced. Accordingly, the likelihood of end surfaces of the divided base semiconductor layer 8 being damaged can be reduced. When the base semiconductor layer 8 is cleaved so as to be torn from the starting portion 8K, the cleavage plane tends to be smooth.

In Example 1, when cooling the semiconductor substrate 10, the base semiconductor layer 8 and the compound semiconductor layer 9 may be cleaved, and isolated into multiple semi-element portions sDS including the optical cavities LK on the template substrate 7. In this case, an additional process for cleaving the base semiconductor layer 8 and the compound semiconductor layer 9 is not necessary, thereby reducing the manufacturing costs of the laser diode element 20. The semi-element portion sDS including the optical cavity LK with a short cavity length can be manufactured. For example, the length of the distance L2 can be about 20 µm to 200 µm, and thus the cavity length L1 can be about 20 µm to 200 µm.

After cooling the semiconductor substrate 10, when there is the starting portion 9T where no dividing portion PS has been generated, that is, there is the starting portion 9T where no cleavage has occurred, a process of cleaving the starting portion 9T may be further performed. For example, cleavage may be generated at the starting portion 9T by applying force in a direction perpendicular to the surface direction while applying a blade to the starting portion 9T. In this case, cleavage can be relatively reliably generated at the starting portion 9T, thereby improving the yield. Alternatively, cleavage may be generated at the starting portion 9T by applying vibration to the starting portion 9T. In this case, the manufacturing process can be simplified because the process can be performed relatively easily. Further, by raising or lowering a temperature of the semiconductor substrate 10 from room temperature, thermal stress utilizing a difference in thermal expansion coefficient between the main substrate 1 and the base semiconductor layer 8 may be applied to the starting portion 9T to generate cleavage.

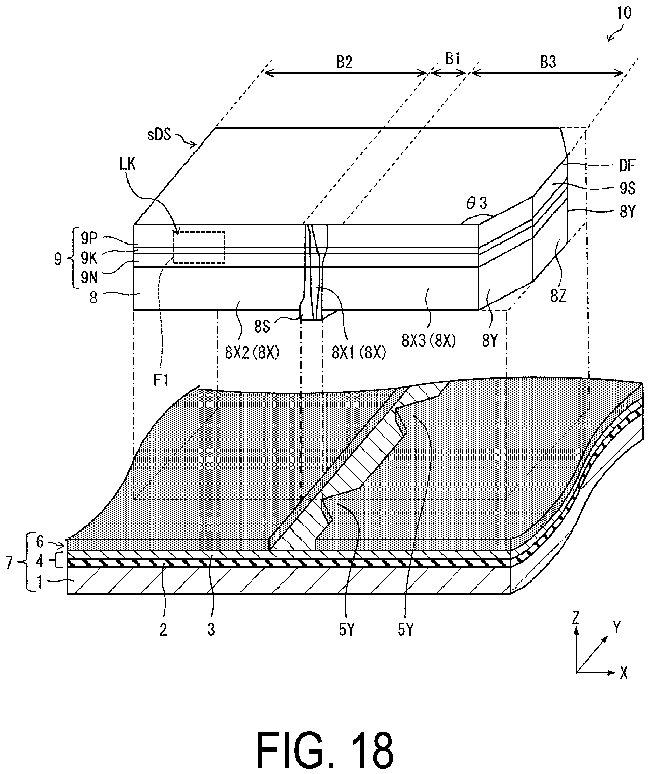

FIG. 18 is an exploded perspective view for explaining a configuration of the semi-element portion sDS in Example 1. Although the template substrate 7 and the base semiconductor layer 8 are virtually separated from each other in FIG. 18 for convenience of description, in reality, the base semiconductor layer 8 and the mask portion 5 are in contact with each other. The base semiconductor layer 8 includes a bonding portion 8S on the lower surface corresponding to the initial growth layer SL, and the bonding portion 8S and the seed layer 3 are bonded to each other. In FIG. 18, part of the template substrate 7 is illustrated, not the entirety.

As illustrated in FIG. 18, the base semiconductor layer 8 in the semi-element portion sDS includes a first base end surface 8X and a second base end surface 8Y at an angle and adjacent to the first base end surface 8X. The base semiconductor layer 8 may include a third base end surface 8Z at an angle and adjacent to the second base end surface 8Y and corresponding to the a-plane of the GaN-based semiconductor (e.g., parallel to the a-plane). The second base end surface 8Y may be located between the first base end surface 8X and the third base end surface 8Z. The semi-element portion sDS may include two first base end surfaces 8X and two second base end surfaces 8Y as end surfaces of the third part B3.

The first base end surface 8X may include a first partial surface 8X1, a second partial surface 8X2, and a third partial surface 8X3. The first partial surface 8X1 is a portion of the first base end surface 8X, and is a surface at a position corresponding to the first part B 1 of the base semiconductor layer 8. The second partial surface 8X2 is a partial surface at a position corresponding to the second part B2 in the first base end surface 8X. The third partial surface 8X3 is a partial surface at a position corresponding to the third part B3 in the first base end surface 8X. The first partial surface 8X1 is located between the second partial surface 8X2 and the third partial surface 8X3.

The third partial surface 8X3 may be a surface in which a portion corresponding to the oblique contact portion 8N described above is divided, and may be a cleavage plane, which is an m-plane formed by cleaving the base semiconductor layer 8 starting from the starting portion 8K. The second partial surface 8X2 may be a cleavage plane, which is an m-plane formed by cleaving the base semiconductor layer 8 starting from the starting portion 8K, and may be flush with the emission surface F1 of the optical cavity LK. The first partial surface 8X1, the second partial surface 8X2, and the third partial surface 8X3 can be flush with one another. The surface roughness of the second partial surface 8X2 can be smaller than that of the third partial surface 8X3. The density of dislocations (CL-measured dislocations at the cleavage plane, mainly basal plane dislocations) in the second partial surface 8X2 may be higher than or equal to the threading dislocation density in the second part B2.

The second base end surface 8Y is a surface included in the starting portion 8K having the notch shape in the base semiconductor layer 8 before cleavage, and is not a cleavage plane formed by cleavage. Depending on the shape of the starting point inducing portion 5Y of the mask portion 5, the starting portion 8K may include the end surface of the ELO semiconductor layer grown in the m-axis direction. In this case, the second base end surface 8Y is not a cleavage plane but may be an m-plane of the GaN-based semiconductor. The compound semiconductor part 9 may include a side surface 9S located above the second base end surface 8Y. The surface roughness of at least one of the pair of cavity surfaces (the emission surface F1 and the facing surface F2) can be made smaller than the surface roughness of the side surface 9S.

An angle (internal angle) formed by the first base end surface 8X and the second base end surface 8Y is referred to as θ3. The angle θ3 may be an obtuse angle, for example, 120° or substantially 120°, for example, about 110° to 130°.

As described above, in Example 1, by isolating the base semiconductor layer 8 and the compound semiconductor layer 9 into multiple first element portions (semi-element portions sDS), the optical cavity LK (see FIGs. 1 and 2) including the cavity surfaces can be formed. In FIG. 18, the optical cavity LK is exemplarily illustrated at a position overlapping the second part B2 in plan view, but the position of the optical cavity LK in the X direction is not necessarily limited in the semi-element portion sDS. The optical cavity LK will be described later in more detail.

In Example 1, it can also be said that the optical cavity LK including the cavity surfaces is formed by dividing the base semiconductor layer 8 and the compound semiconductor layer 9 so that not the entire main substrate 1 in the thickness direction is divided.

Each of the emission surface F1 and the facing surface F2 of the optical cavity LK may be an m-plane of the compound semiconductor layer 9, and may be included in a cleavage plane of the compound semiconductor layer 9. Each of the emission surface F1 and the facing surface F2 can be formed by cleaving along the m-plane of the compound semiconductor layer 9, which is a nitride semiconductor layer (e.g., a GaN-based semiconductor layer). In the semi-element portion sDS, the base semiconductor layer 8 and/or the compound semiconductor layer 9 may have a trace of a cleavage starting point for cleavage (e.g., the second base end surface 8Y). Since the emission surface F1 and the facing surface F2 are m-planes, the reflectance of the cavity surfaces of the optical cavity LK can be improved.

### Step of Forming Element Structure

Subsequently, a step of forming an element structure is performed on the semiconductor substrate 10 including the multiple semi-element portions sDS. For example, the element portion DS is formed by forming the ridge portion RJ in the p-type semiconductor layer 9P, and then forming the insulating film DF and the first electrode E1. In Example 1, the laser diode element 20 having a double-sided electrode structure is manufactured. Accordingly, the element portion DS does not include the second electrode E2, and the second electrode E2 may be provided in a later step.

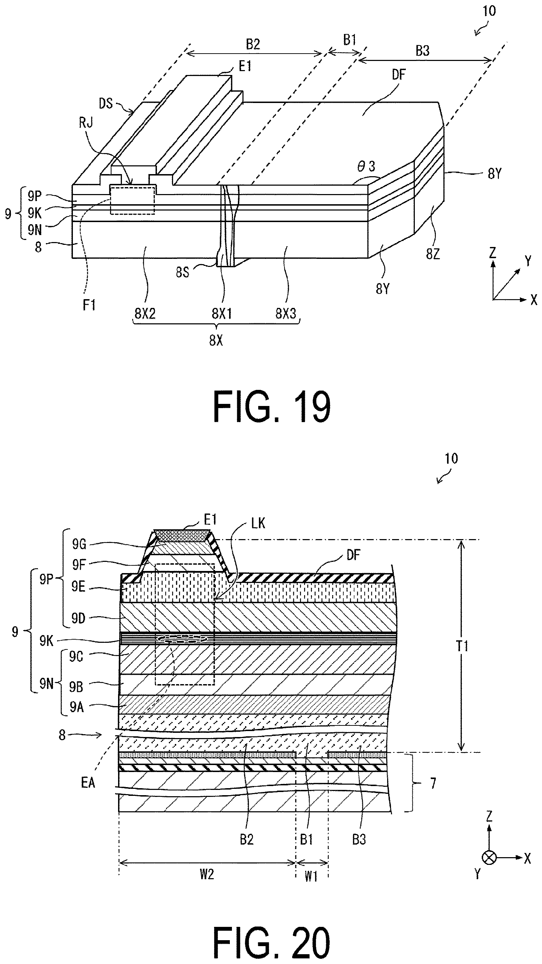

FIG. 19 is a perspective view for explaining a configuration of the element portion DS in Example 1. In FIG. 19, the template substrate 7 is omitted from the figure. FIG. 20 is a cross-sectional view illustrating the configuration of the element portion DS in Example 1.

As illustrated in FIGs. 19 and 20, the compound semiconductor layer 9 may include the ridge portion RJ overlapping the first electrode E1 in plan view. The ridge portion RJ may include the second cladding layer 9F and part of the electron blocking layer 9E (see FIG. 15) (part overlapping the first electrode E1 in plan view). The ridge portion RJ is shaped with the Y direction as the longitudinal direction, and the insulating film DF may be provided so as to cover side surfaces of the ridge portion RJ. For the insulating film DF, a single-layer film or a laminate film containing, for example, an oxide or a nitride of Si, Al, Zr, Ti, Nb, or Ta can be used. The thickness of the insulating film DF can be about 10 to 500 nm.

The refraction index of the insulating film DF is smaller than the refraction indices of the second optical guiding layer 9D and the second cladding layer 9F. By providing the ridge portion RJ and the insulating film DF, a current path between the first electrode E1 and the base semiconductor layer 8 is narrowed on an anode side, enabling efficient light emission in the cavity LK.

The first electrode E1 is provided, for example, on the upper surface of the ridge portion RJ and functions as an anode. Examples of a material of the first electrode E1 include single-layer films and multilayer films of metals such as Ni, Rh, Cr, Au, W, Pt, Ti, and Al, alloys thereof, and electrically conductive oxides containing at least one selected from the group consisting of Zn, In, and Sn. Examples of the electrically conductive oxide include indium tin oxide (ITO), indium zinc oxide (IZO), and gallium-doped zinc oxide (GZO). The thickness of the first electrode E1 is, for example, about 0.1 µm to 2 µm.

The optical cavity LK includes part of the n-type semiconductor layer 9N, part of the active layer 9K, and part of the p-type semiconductor layer 9P (portions overlapping the first electrode E1 in plan view). For example, the optical cavity LK includes part of the first cladding layer 9B, part of the first optical guiding layer 9C, part of the active layer 9K, part of the second optical guiding layer 9D, part of the electron blocking layer 9E, and part of the second cladding layer 9F (portions overlapping the first electrode E1 in plan view).

In the optical cavity LK, the refraction index (optical refraction index) decreases in the order of the active layer 9K, the first optical guiding layer 9C, and the first cladding layer 9B, and the refraction index decreases in the order of the active layer 9K, the second optical guiding layer 9D, and the second cladding layer 9F. Thus, light generated by coupling of holes supplied from the first electrode E1 and electrons supplied from the second electrode E2 in the active layer 9K is confined in the optical cavity LK (in particular, in the active layer 9K), and laser oscillation occurs due to stimulated emission and feedback in the active layer 9K. A laser beam generated by the laser oscillation is emitted from a light emitting area EA of the emission surface F1.

Since the emission surface F1 and the facing surface F2 of the optical cavity LK are formed by cleaving along m-planes, they have excellent flatness and perpendicularity to the c-plane (parallelism between the emission surface F 1 and the facing surface F2) and have high light reflectance. Thus, return loss can be reduced, and stable laser oscillation is possible even at short resonance lengths of 200 µm or less where an optical gain is small. The emission surface F 1 and the facing surface F2 are formed above the second part B2, which is a low dislocation part, resulting in excellent flatness of the cleavage planes and high light reflectance.

In Example 1, the sum T1 of the thickness of the base semiconductor layer 8 and the thickness of the compound semiconductor layer 9 can be 50 [µm] or less. When the sum T1 of these thicknesses is too large, it may be difficult to cleave the cavity to a length of 200 µm or less. A ratio of the cavity length L 1 (see FIG. 2) to the thickness of the second part B2 of the base semiconductor layer 8 can be 1 to 20. When a direction orthogonal to the direction of the cavity length L1 is a first direction (X direction) and the size of the second part B2 in the X direction is a width W2 of the second part B2, the ratio of the cavity length L1 to the width W2 of the second part B2 can be 1 to 10. When the size of the first part B 1 in the X direction is a width W1 of the first part B 1, the ratio of the cavity length L1 to the width W1 of the first portion can be 1 to 200.

### Step of Separating Element Portion from Template Substrate

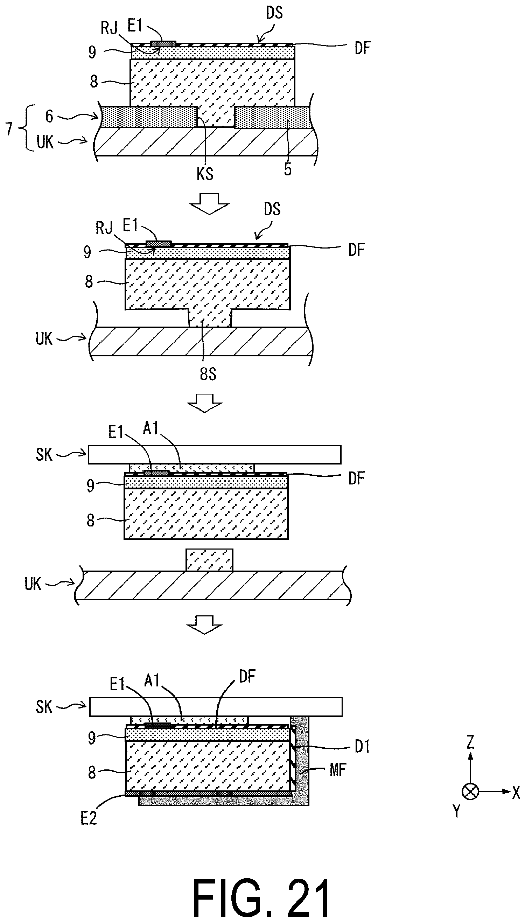

Subsequently, a step of separating the element portion DS from the template substrate 7 is performed. FIG. 21 schematically illustrates cross-sectional views of several steps of separating the element portion DS from the template substrate 7 in the manufacturing method for the laser diode element in Example 1. Although one element portion DS is illustrated in FIG. 21, it is needless to say that a process of separating multiple element portions DS from the template substrate 7 may be performed. In FIG. 21, the ridge portion RJ is simplified.

As illustrated in FIG. 21, first, the mask portion 5 of the template substrate 7 may be removed by etching using hydrofluoric acid, buffered hydrofluoric acid, or the like. The insulating film DF may be protected with a resist or the like so that the insulating film DF is not removed together with the mask portion 5. In Example 1, the mask portion 5 may be removed after forming the element portion DS on the template substrate 7. In this case, since the mask portion 5 can be removed while the element portion DS is fixed to the template substrate 7, the yield when manufacturing the laser diode element 20 can be improved. By removing the mask portion 5, the base semiconductor layer 8 and the underlying substrate UK are bonded via the bonding portion 8S (fragile portion), so that the element portion DS can be easily separated from the underlying substrate UK.

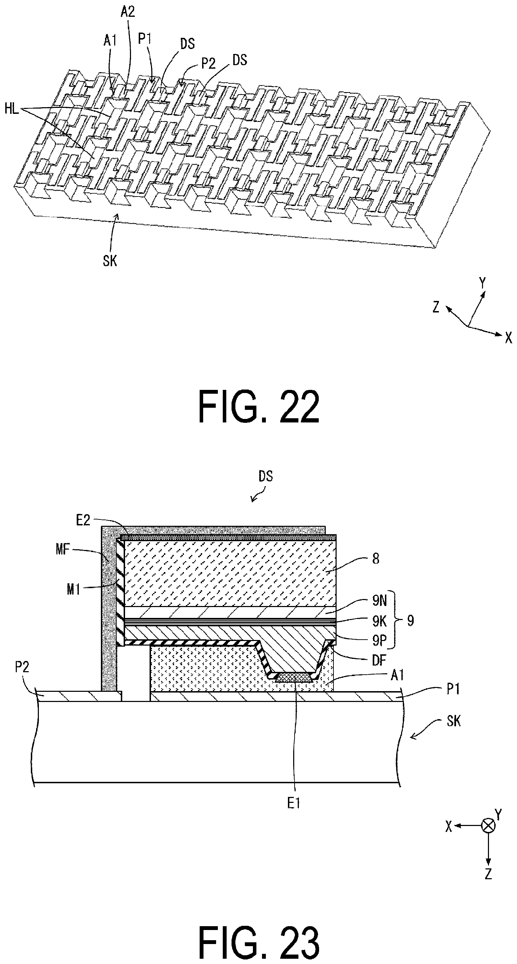

Subsequently, for example, the step of separating the element portion DS from the template substrate 7 may be performed in conjunction with a step of bonding the element portion DS to a support substrate SK. A specific shape of the support substrate SK is not limited, but the support substrate SK in Example 1 will be described below with reference to FIGs. 22 and 23. FIG. 22 is a perspective view schematically illustrating a state in which the element portion DS is bonded to the support substrate SK. FIG. 23 is a cross-sectional view schematically illustrating the state in which the element portion DS is bonded to the support substrate SK.

As illustrated in FIGs. 21 to 23, the support substrate SK includes an electrically conductive first pad P1 and an electrically conductive second pad P2, and for example, the first electrode E1 may be connected to the first pad P1 via a first bonding part A1. By bonding the first electrode E1 and/or the first bonding part A1, the element portion DS is supported by the support substrate SK. Thus, the bonding portion 8S (fragile portion) protruding downward on the back surface of the base semiconductor layer 8 is broken, and the element portion DS can be separated from the template substrate 7. The insulating film DF and the second pad P2 may be bonded to each other via the second bonding part A2 (not illustrated). In this case, the stability of a state in which the element portion DS is supported by the support substrate SK can be improved. The back surface of the base semiconductor layer 8 may be flattened by polishing, chemical mechanical polish (CMP), or the like. Then, the second electrode E2 can be formed on the lower surface of the base semiconductor layer 8 of the element portion DS while being supported by the support substrate SK.

Subsequently, (i) an insulating film D1 that covers side surfaces of the base semiconductor layer 8 and the compound semiconductor layer 9, and (ii) an electrically conductive film MF are formed. The electrically conductive film MF electrically connects the second electrode E2 and the second bonding part A2 or the second pad P2. There is no limitation regarding the material used for the electrically conductive film MF. The first pad P1 and the second pad P2 may be separated from each other. The electrically conductive film MF may be in contact with the second electrode E2, the insulating film D1, and the second bonding part A2 and/or the second pad P2.

In Example 1, the second electrode E2 is located on the back surface of the base semiconductor part 8, and the compound semiconductor part 9 and the first electrode E1 are closer to the support substrate SK than the base semiconductor part 8 (junction-down configuration).

The multiple element portions DS may be arranged on the support substrate SK in a direction (X direction) orthogonal to the direction defining the cavity length so that the directions of the cavity lengths are aligned, and the support substrate SK may be provided with the first and second pads P1 and P2 corresponding to the respective multiple element portions DS.

The support substrate SK can be formed, for example, as follows. That is, multiple recessed portions HL (rectangular in plan view) are provided in a matrix in a Si substrate, a SiC substrate, an AlN substrate, or the like, and the multiple first pads P1, the multiple second pads P2, and the multiple first bonding parts A1 are provided on a non-recessed portion. Note that the multiple second bonding parts A2 may be provided. There is no limitation regarding the material constituting the body portion of the support substrate SK, and the support substrate SK may be made of, for example, an insulator or a semi-insulator, or may be made of an electrically conductive material. Examples of the electrically conductive material include metal materials containing Cu and Al. When the support substrate SK is made of an electrically conductive material, an insulation layer may be placed on an upper surface of the support substrate SK, and wiring may be placed on the insulation layer.

There is no limitation regarding the shape of the support substrate SK, and the shape may be a substantially quadrilateral prism shape (a substantially rectangular parallelepiped shape), a substantially pentagonal prism shape, a substantially hexagonal prism shape, or the like, or may be any other shape. In Example 1, the support substrate SK has a substantially rectangular parallelepiped shape.

The first pad P1 and the second pad P2 may include metal layers containing, for example, Au, Ti, or Ni. The first bonding part A1 and the second bonding part A2 may be made of a single metal layer or may be made of multiple metal layers. When the first bonding part A1 and the second bonding part A2 are made of the multiple metal layers, the outermost surface may be a metal layer made of Au. This can suppress corrosion of the first bonding part A1 and the second bonding part A2. The first bonding part A1 is a solder material such as AuSi or AuSn, for example. The first pad P1 and the first electrode E1 may be metal-to-metal bonded without providing the first bonding part A1, and the second pad P2 and the second electrode E2 may be metal-to-metal bonded without providing the second bonding part A2. In this case, for example, Au-Au bonding can be used.

The first pad P1 and the second pad P2 may be located on the same plane. In Example 1, the second bonding part A2 need not be provided. The first bonding part A1 may be, for example, a solder material, and the element portion DS may be placed on the support substrate SK while being held by the first bonding part A1.

### Step of Forming Reflection Film on Cavity Surfaces

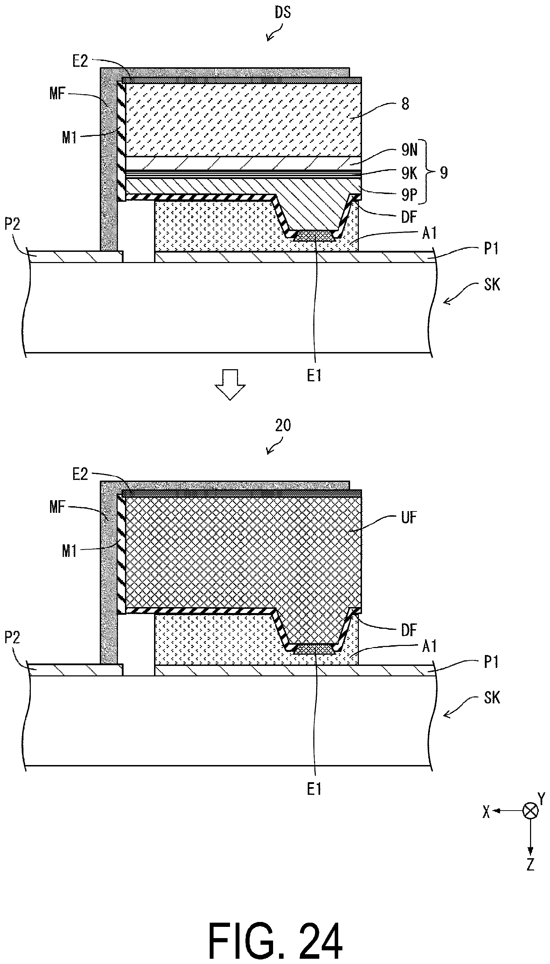

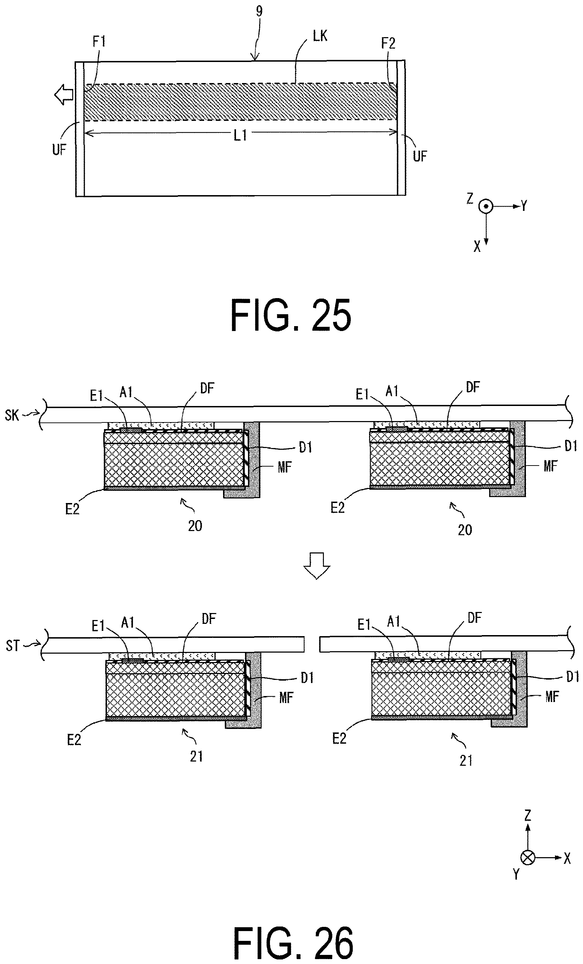

Subsequently, a reflector film UF is deposited on the emission surface F1 and the facing surface F2 of the optical cavity LK in the element portion DS mounted on the support substrate SK. Thus, the laser diode element 20 can be manufactured. FIG. 24 schematically illustrates cross-sectional views of several steps of forming the reflection film on the cavity surfaces in the manufacturing method for the laser diode element in Example 1. FIG. 25 is a plan view illustrating a configuration of the compound semiconductor layer 9 after depositing the reflector film UF.

As illustrated in FIGs. 24 and 25, the reflector film UF (e.g., a dielectric film) is formed on a first end surface including the end surface of the base semiconductor layer 8 and the end surface of the compound semiconductor layer 9. The first end surface includes the emission surface F1 of the optical cavity LK. Examples of a material of the reflector film UF include dielectrics such as SiO₂, Al₂O₃, AlN, AlON, Nb₂O₅, Ta₂O₅, and ZrO₂. The reflector film UF may be a multilayer film. The reflector film UF can be formed by electron beam deposition, electron cyclotron resonance sputtering, chemical vapor deposition, or the like.

In the laser diode element 20, at least one of the pair of cavity surfaces (the emission surface F1 and the facing surface F2) has a light reflectance of 98% or more, and the cavity length L1 can be 200 [µm] or less. The emission surface F1 and the facing surface F2 may differ in terms of reflectance. The cavity surface having the lower reflectance can be used as the emission surface F1. The reflectance can be controlled by the type, structure, film thickness, and the like of the reflector film UF.

The reflector film UF may be provided so as to cover the facing surface F2. The light reflectance of each of the emission surface F1 and the facing surface F2 may be 98% or more. The light reflectance of the facing surface F2 on the light reflecting surface side is greater than the light reflectance of the emission surface F1. The reflector film UF can be formed on entire cleavage planes (m-planes) of the base semiconductor layer 8 and the compound semiconductor layer 9.

As described above, the element portion DS can be electrically connected and mechanically fixed to the support substrate SK. Thus, the element portion DS is placed on the support substrate SK with the end surfaces exposed. Accordingly, the reflection film can be formed on the emission surface F1 and the facing surface F2 of the optical cavity LK on the end surfaces of the element portion DS in the subsequent step. In other words, in a state in which the element portion DS is placed on the template substrate 7 (a state before the element portion DS is separated from the template substrate 7), it is difficult to form the reflection film on the emission surface F1 and the facing surface F2 of the optical cavity LK because the cavity surfaces are not exposed to the outside in the dividing portions PS.

In general, when manufacturing laser diode elements, dielectric layers can be deposited (coated on the end surfaces) so that the cavity surfaces of multiple elements have a desired reflectance.

In order to do this, by using the support substrate SK, the coating of the cavity surfaces of the element portion DS can be appropriately performed after the element isolation. The support substrate SK has the role of a jig when coating the end surfaces of the optical cavity LK, and also functions as a submount in the final device (laser diode element 20). In Example 1, by performing the coating process on the element portion DS fixed to the support substrate SK, the reflection efficiency on the facing surface F2 is increased, enabling the laser diode element 20 with excellent light emission efficiency. Further, end surface optical damage on the emission surface F1 can be suppressed, enabling the laser diode element 20 with excellent reliability.

In the known technique CT, when forming the cavity surfaces of the optical cavity by, for example, cleavage, both the growth substrate and the structure formed on the growth substrate are cleaved, which limits shortening of the cavity length. As far as the inventors are aware, the minimum cavity length of commercially available laser diodes manufactured by a technique of forming cavity surfaces by cleavage is about 300 µm. On the other hand, the laser diode element 20 can include an ultra-short cavity of 20 µm to 200 µm. Since at least one of the cavity surfaces (the emission surface F1 and the facing surface F2) has high light reflectance and low return loss, stable laser oscillation is possible even at short resonance lengths of 200 µm or less, at which the optical gain is small. The short cavity length enables low power consumption in low light output applications such as wearable devices.

### Step of Dividing Support Substrate

Subsequently, the support substrate SK may be divided into multiple support bodies ST. Thus, a laser diode chip 21 in which one or more laser diode elements 20 are held by the support body ST can be obtained. FIG. 26 schematically illustrates cross-sectional views of several steps of dividing the support substrate SK in the manufacturing method for the laser diode element in Example 1.

As illustrated in FIG. 26, the support substrate SK is divided to form the multiple laser diode chips 21, each including the laser diode element 20. The support body ST can be used as a substrate (also referred to as a submount) of the laser diode chip 21. The laser diode chip 21 functions as a COS (chip on submount).

The support substrate SK may be divided into the support bodies ST using a known cutting method such as dicing or scribing. The support substrate SK may be cut at any desired location while avoiding damage to the laser diode element 20. The support body ST may be provided with one laser diode element 20, or may be provided with two or more laser diode elements 20.

In Example 1 as described above, the base semiconductor layer 8 and the compound semiconductor layer 9 are spontaneously cleaved on the template substrate 7 to be isolated into the multiple semi-element portions sDS. Therefore, there is no need to add a separate step for cleaving the base semiconductor layer 8 and the compound semiconductor layer 9. As a result, the manufacturing costs of the laser diode element 20 can be reduced.

### Other Configurations of Example 1

1A
The multiple base semiconductor layers 8 need not be formed in an island shape by the ELO method; adjacent base semiconductor layers 8 may be made to come into contact with each other by making the growth time for depositing the base semiconductor layers 8 relatively long. In this case, the upper surface of the base semiconductor layer 8 may be polished. The compound semiconductor layer 9 can be deposited on the flat base semiconductor layer 8. The base semiconductor layer 8 and the compound semiconductor layer 9 may be subjected to dry etching or the like to form the compound semiconductor layer 9 including the starting portion 9T. The base semiconductor layer 8 including the starting portion 8K may be formed. Thus, the semiconductor substrate 10 capable of performing element isolation on the template substrate 7 can be obtained. For example, the semiconductor substrate 10 may include the base semiconductor layer 8 and the compound semiconductor layer 9 as illustrated in FIG. 16.

### 1B

After growing the base semiconductor layer 8 on the template substrate 7 in the MOCVD system and before depositing the compound semiconductor layer 9, the semiconductor substrate 10 may be temporarily taken out from the MOCVD system. In this case, by taking out the semiconductor substrate 10 from the MOCVD system, cleavage may occur in the base semiconductor layer 8. Thereafter, the semiconductor substrate 10 including the cleaved base semiconductor layer 8 may be placed in the MOCVD system, and the compound semiconductor layer 9 including the starting portion 9T may be deposited. In this case, the end surfaces of the epitaxially grown compound semiconductor layer 9 include the emission surface F1 and the facing surface F2. By epitaxially growing the compound semiconductor layer 9 on the base semiconductor layer 8 including high-quality cleavage planes, the end surfaces of the compound semiconductor layer 9 can be of high quality. Accordingly, the end surfaces of the epitaxially grown compound semiconductor layer 9 can be used as cavity surfaces.

### 1C

In Example 1, the mask portion 5 was removed after the element portion DS was formed on the template substrate 7. However, in another configuration example, the mask portion 5 may be removed before the step of forming the element portion DS. For example, after forming the semi-element portion sDS by element isolation on the template substrate 7, the mask portion 5 may be removed before forming the element portion DS. In this case, there is an advantage that it is not necessary to protect the insulating film DF so that the insulating film DF is not removed when removing the mask portion 5.

### 1D

In still another configuration example, after forming the second electrode E2 and the reflector film UF while supporting the element portion DS using a temporary substrate, the laser diode element 20 may be mounted on the support substrate SK. Further, with the laser diode element 20 held between the temporary substrate and the support substrate SK, both the temporary substrate DK and the support substrate SK may be divided. In this case, divided pieces of the temporary substrate DK may be removed.

A first support substrate including wiring may be used instead of the temporary substrate DK. In this case, with the laser diode element 20 held between the first support substrate and the support substrate SK (second support substrate), both the first support substrate and the support substrate SK may be cut. Thus, the laser diode chip 21 may include the single piece of the first support substrate and the support body ST.

### 1E

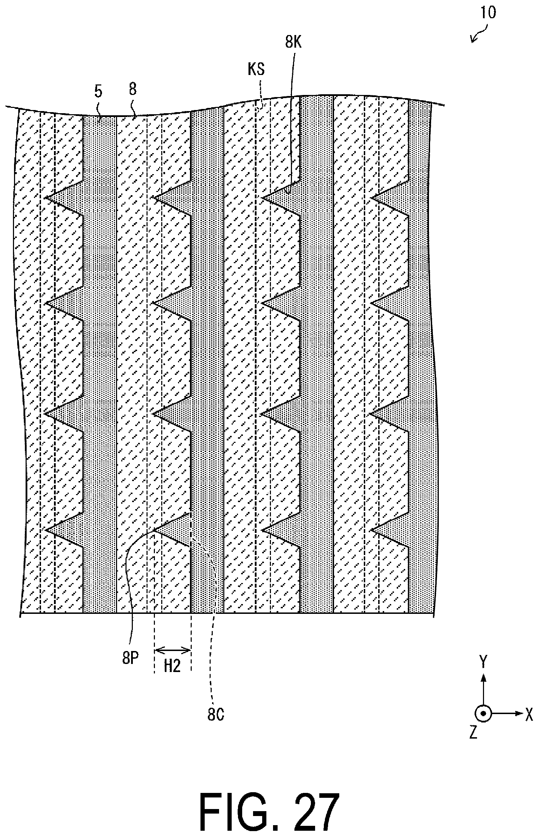

FIG. 27 is a plan view for explaining yet another example of the base semiconductor layer 8 in Example 1. As illustrated in FIG. 27, the base semiconductor layer 8 in the yet another example may include the starting portion 8K that is notched up to a position close to the starting point inducing portion 5Y in plan view. A tip at the starting portion 8K is referred to as a tip portion 8P. For example, the starting portion 8K may be located at a position where the tip portion 8P overlaps the starting point inducing portion 5Y in plan view. The starting portion 8K may have a virtual triangular shape in plan view. In this virtual triangle, a virtual line segment corresponding to a base when the tip portion 8P is an apex is referred to as a side 8C. A distance from the side 8C to the tip portion 8P is referred to as a notch length H2 of the starting portion 8K. The notch length H2 may be WM/4 or more, or may be WM/3 or more, using the width WM of the mask portion 5 (see FIG. 4). The notch length H2 may be WM/2 or less.

By forming the compound semiconductor layer 9 on the base semiconductor layer 8, the compound semiconductor layer 9 is formed into a shape including a starting portion (not illustrated) corresponding to the starting portion 8K. The starting portion formed in the compound semiconductor layer 9 may include end surfaces that are the m-planes of the GaN-based semiconductor by being formed in the shape corresponding to the starting portion 8K. The end surfaces of the starting portion formed in the compound semiconductor layer 9 do not need to be the m-planes of the GaN-based semiconductor.

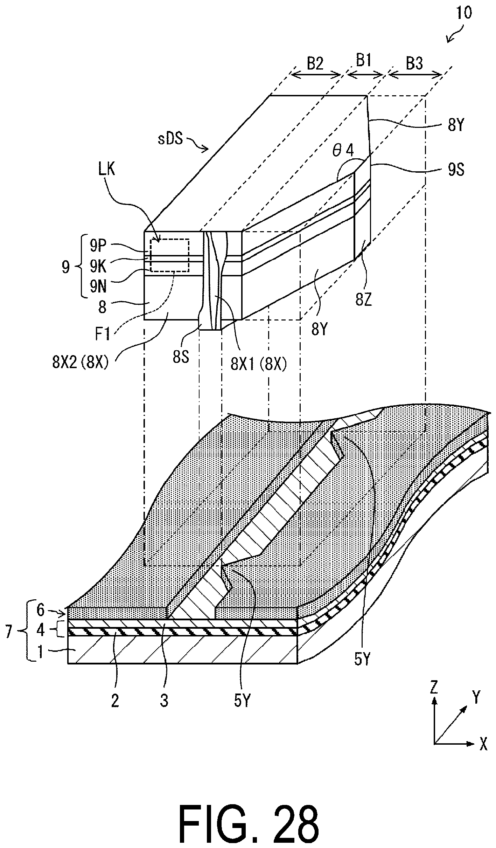

FIG. 28 is an exploded perspective view for explaining a configuration of the semi-element portion sDS formed by isolating the base semiconductor layer 8 and the compound semiconductor layer 9 into elements. Although the template substrate 7 and the base semiconductor layer 8 are virtually separated from each other in FIG. 28 for convenience of description, in reality, the base semiconductor layer 8 and the mask portion 5 are in contact with each other. The base semiconductor layer 8 includes the bonding portion 8S on the lower surface corresponding to the initial growth layer SL, and the bonding portion 8S and the seed layer 3 are bonded to each other. In FIG. 28, part of the template substrate 7 is illustrated, not the entirety.

As illustrated in FIG. 28, in the base semiconductor layer 8 of the semi-element portion sDS in the yet another example, the first base end surface 8X does not need to include the third partial surface 8X3. An angle (internal angle) formed by the second base end surface 8Y and the third base end surface 8Z is referred to as θ4. θ4 may be an obtuse angle, for example, 120° or substantially 120°, for example, about 110° to 130°. Alternatively, θ4 may be greater than 130°. The second base end surface 8Y may be the m-plane of the GaN-based semiconductor.

### 1F

In a further configuration example of Example 1, in the element portion DS, a portion of the compound semiconductor layer 9 may be removed by etching or the like, or the compound semiconductor layer 9 may be partially formed on the base semiconductor layer 8. In this case, the first electrode E1 may be connected to the first pad P1 via the first bonding part A1, and the second electrode E2 may be connected to the second pad P2 via the electrically conductive film MF and the second bonding part A2. In this example, the element portion DS can be mounted on the support substrate SK without forming the insulating film D1 covering the side surfaces of the base semiconductor layer 8 and the compound semiconductor layer 9.

### Example 2

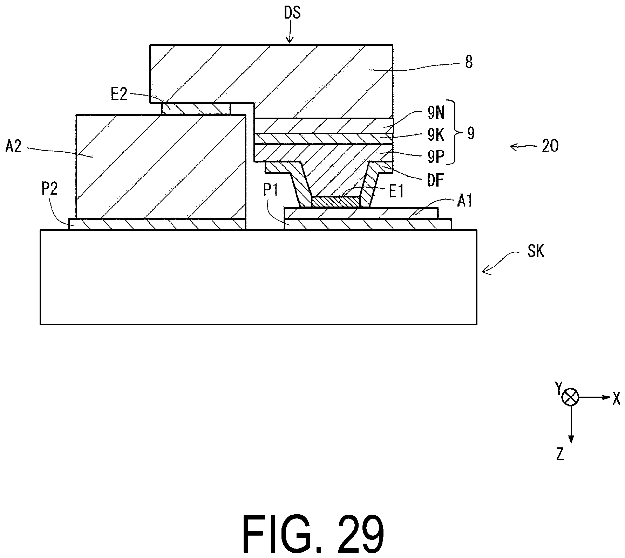

In Example 1, the laser diode element 20 has a double-sided electrode structure, but in Example 2, the laser diode element 20 may have a single-sided two-electrode structure. FIG. 29 is a cross-sectional view illustrating a configuration of the laser diode element 20 in Example 2.

As illustrated in FIG. 29, the laser diode element 20 in Example 2 may include the element portion DS including the base semiconductor layer 8 and the compound semiconductor layer 9, and the support substrate SK holding the element portion DS. Examples of a material for the support substrate SK include Si, SiC, and AlN. The support substrate SK is placed such that the compound semiconductor layer 9 and the first electrode E1, and the second electrode E2 are located between the support substrate SK and the base semiconductor layer 8.

The first electrode E1 overlaps the optical cavity LK (not illustrated) and the second part B2 of the base semiconductor layer 8 in plan view. The second electrode E2 is provided on the same side as the first electrode E1 with respect to the base semiconductor layer 8. The second electrode E2 is in contact with the base semiconductor layer 8, and the first electrode E1 and the second electrode E2 do not overlap each other in plan view. To be more specific, the base semiconductor layer 8 is wider than the compound semiconductor layer 9 in the X direction, and the second electrode E2 is formed on an exposed portion of the base semiconductor layer 8 where the compound semiconductor layer 9 is not formed. The exposed portion may be formed by removing a portion of the compound semiconductor layer 9 by reactive ion etching (RIE) or the like, or may be formed by partially depositing the compound semiconductor layer 9 on the base semiconductor layer 8. Although not illustrated, the compound semiconductor layer 9 may include the optical cavity LK, and a pair of cavity surfaces of the optical cavity LK may be covered with the reflector film UF.

The support substrate SK is provided with the electrically conductive first pad P1 and the electrically conductive second pad P2. The first electrode E1 is connected to the first pad P1 via the first bonding part A1, and the second electrode E2 is connected to the second pad P2 via the second bonding part A2. In Example 2, the second bonding part A2 is thicker than the first bonding part A1, and a difference in thickness between the first bonding part A1 and the second bonding part A2 is greater than or equal to the thickness of the compound semiconductor layer 9. Thus, the first and second electrodes E1 and E2 can be connected to the first and second pads P1 and P2 located on the same plane.

The support substrate SK may be the divided support body ST. In this case, the laser diode element 20 may be the laser diode chip 21. The support body ST can be used as the substrate (also referred to as the submount) of the laser diode chips 21. The laser diode chip 21 functions as the COS (chip on submount).

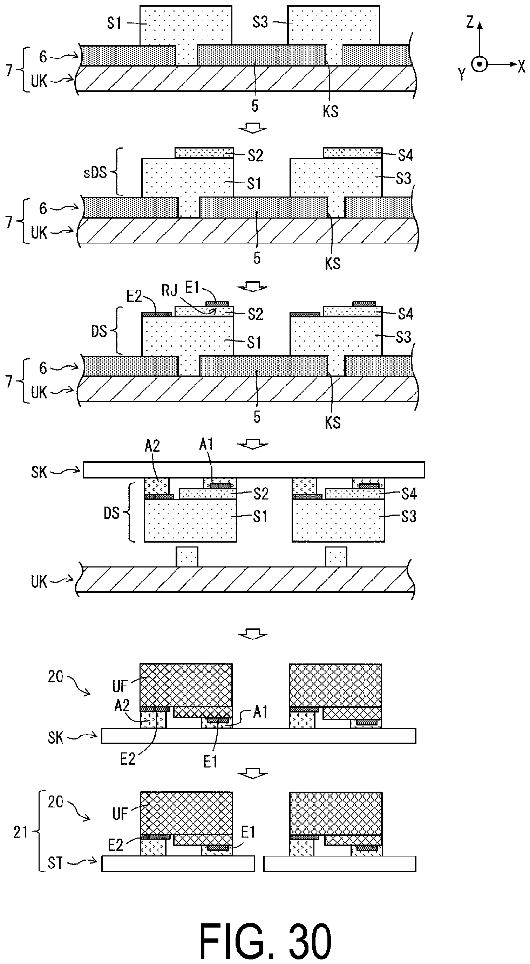

FIG. 30 illustrates schematic cross-sectional views of an example of a manufacturing method for the laser diode element 20 in Example 2. As illustrated in FIG. 30, in Example 2, the manufacturing method includes a step of preparing the template substrate 7 including the underlying substrate UK and the mask layer 6, a step of forming a first semiconductor layer S1 (and a third semiconductor layer S3) to be the base semiconductor layer 8 by the ELO method (described later), and a step of forming a second semiconductor layer S2 (and a fourth semiconductor layer S4) to be the compound semiconductor layer 9. The mask layer 6 including the mask portion 5 with the starting point inducing portion 5Y may be formed. In this case, the first semiconductor layer S1 (and the third semiconductor layer S3) includes the starting portion 8K. When the second semiconductor layer S2 is formed on the first semiconductor layer S1 at a position including the starting portion 8K, the second semiconductor layer S2 can be formed so as to include the starting portion 9T.

The starting portion 8K may be formed in the third part B3, and the second semiconductor layer S2 may be provided above the second part B2. In this case, the optical cavity LK is provided at a position overlapping the second part B2 in plan view. The second semiconductor layer S2 does not need to include the starting portion 9T, and a starting point for cleavage may be formed by scribing as will be described later (Example 3, etc.).

Subsequently, by performing element isolation on the template substrate 7, the semi-element portion sDS is formed. Thereafter, the ridge portion RJ is formed in the first semiconductor layer S1, and the first electrode E1, the second electrode E2, and the like are formed. Thus, the element portion DS having a single-sided two-electrode structure is formed on the template substrate 7.

Then, a step of bonding the element portion DS to the support substrate SK, and separating the first semiconductor layer S1 from the template substrate 7 is performed. For example, after forming the element portion DS, the mask portion 5 is removed by etching, and the element portion DS is bonded to the support substrate SK while heating and melting the first and second bonding parts A1 and A2 (e.g., solder) provided on the support substrate SK. Then, one or both of the support substrate SK and the underlying substrate UK are displaced so that the support substrate SK and the underlying substrate UK move away from each other. Thus, the connecting portion (downward protruding portion) of a back surface of the first semiconductor layer S1 with the underlying substrate UK is broken, and the first semiconductor layer S1 is separated from the template substrate 7. As a result, a two-dimensionally arranged laser diode substrate (see FIG. 22) is formed.

Then, the two-dimensionally arranged laser diode substrate may be divided into rows to form one-dimensionally arranged (rod-shaped) laser diode substrates, and then the reflector film UF is formed on each of the emission surface F1 and the facing surface F2. Subsequently, a step of dividing the support substrate SK into multiple support bodies ST may be performed. By holding one or more laser diode elements 20 on each support body ST, the multiple laser diode chips 21 can be formed.

### Example 3

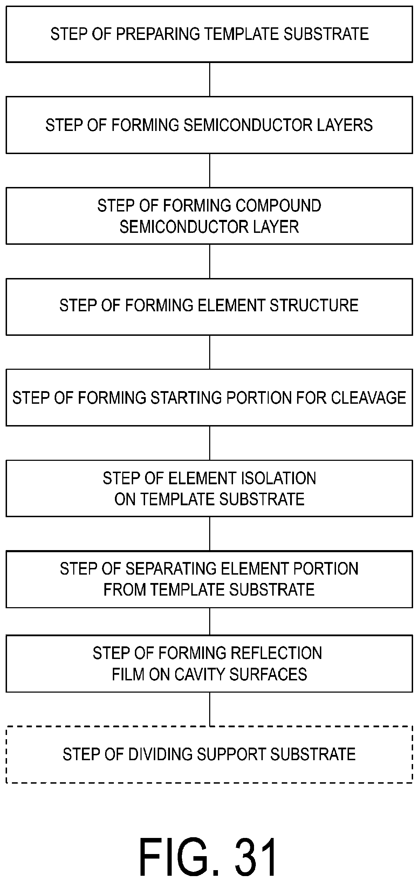

In Example 3, the template substrate 7 that does not include the starting point inducing portion 5Y in the mask portion 5 may be used. In Example 3, the laser diode element 20 having a single-sided two-electrode structure is manufactured. FIG. 31 is a flowchart illustrating an example of a manufacturing method for the laser diode element in Example 3.

As illustrated in FIG. 31, in Example 3, first, the template substrate 7 that does not include a starting point inducing portion in the mask layer 6 (see FIG. 4) is prepared, and then the base semiconductor layer 8 and the compound semiconductor layer 9 are formed on the template substrate 7.

In Example 3, for example, the template substrate 7 may be prepared as follows. First, a silicon oxide film having a thickness of about 100 nm to about 4 µm (preferably about 150 nm to about 2 µm) is formed on the entire surface of the underlying layer 4 by sputtering, CVD, vapor deposition, or the like. Then, a resist is applied to an entire surface of the silicon oxide film. Thereafter, the resist is patterned by photolithography to form the resist having a plurality of stripe-shaped opening portions. Thereafter, by removing the silicon oxide film at several portions using a wet etchant such as hydrofluoric acid (HF) or buffered hydrofluoric acid (BHF), the multiple opening portions KS and the multiple mask portions 5 are formed. Subsequently, the resist is removed by organic cleaning to form the mask layer 6. Thus, the template substrate 7 as illustrated in FIG. 4 can be obtained.

Subsequently, the template substrate 7 is placed in an MOCVD system, and a GaN-based semiconductor layer is deposited by the ELO method. In Example 3, the base semiconductor layer 8 was an n-type GaN layer, and ELO deposition of Si-doped GaN was performed on the template substrate 7 using the MOCVD system. The following may be adopted as examples of the ELO deposition conditions: substrate temperature: 1120°C, growth pressure: 50 kPa, TMG (trimethylgallium): 22 sccm, NH₃: 15 slm, and V/III = 6000 (ratio of group V raw material supply amount to group III raw material supply amount). The initial growth layer SL was selectively grown on the seed layer 3 (the GaN layer that is the uppermost layer of the seed layer 3) exposed through the opening portion KS, and subsequently laterally grown on the mask portion 5. The lateral growth was stopped before the base semiconductor layers 8, which grew laterally from both sides on the mask portion 5, came into contact with each other.

Note that the deposition time may be further increased to allow adjacent base semiconductor layers 8 to come into contact with each other. When the adjacent base semiconductor layers 8 came into contact with each other, after the compound semiconductor layer 9 is formed on the base semiconductor layer 8, the contact portion of the base semiconductor layers 8 may be removed by dry etching or the like.

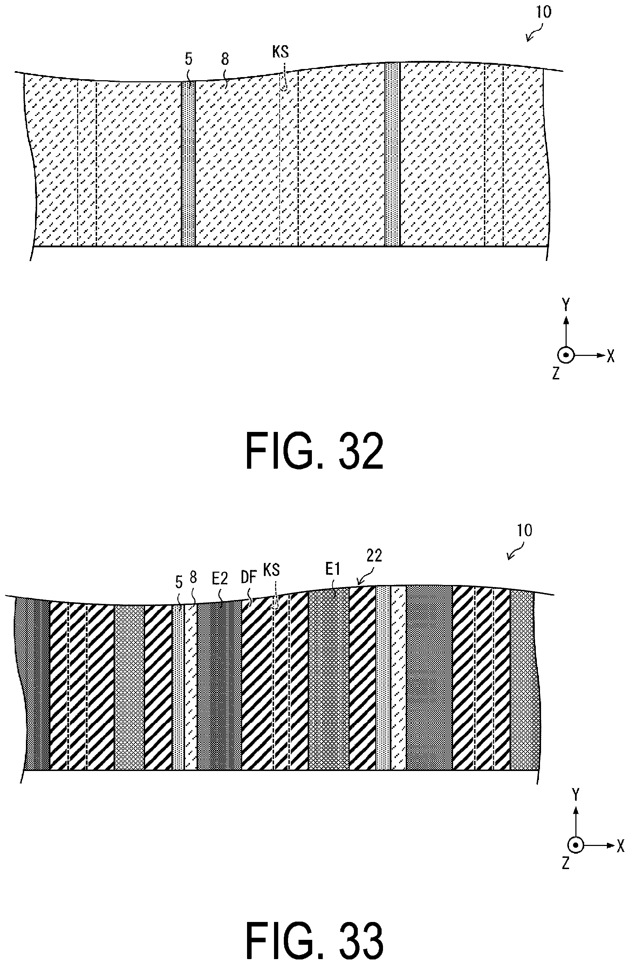

FIG. 32 is a plan view illustrating a configuration of the semiconductor substrate 10 in which the base semiconductor layer 8 is deposited in Example 3. As illustrated in FIG. 32, in Example 3, the base semiconductor layer 8 does not include the starting portion 8K.

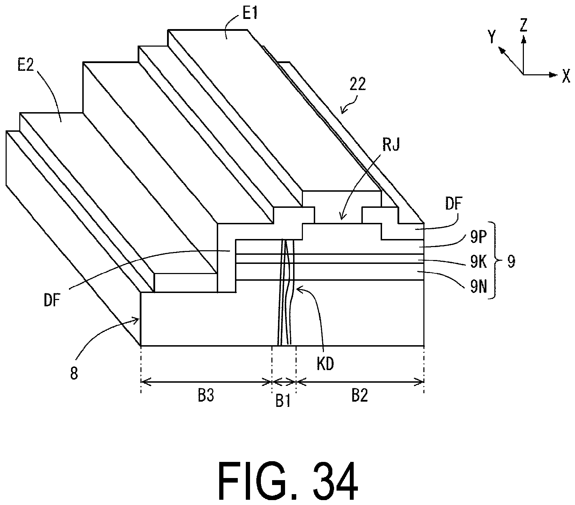

Subsequently, a step of forming the compound semiconductor layer 9, a step of forming the element structure, and a step of forming a starting portion for cleavage are performed. FIG. 33 is a plan view illustrating a configuration of the semiconductor substrate 10 in which the element structure is formed in Example 3. FIG. 34 is a cross-sectional view illustrating the configuration of the semiconductor substrate 10 in FIG. 33. In FIG. 34, the template substrate 7 is omitted from the figure.

The compound semiconductor layer 9 may be formed on the entire surface of the base semiconductor layer 8. In this case, a portion of the base semiconductor layer 8 may be exposed by reactive ion etching. Alternatively, the compound semiconductor layer 9 may be partially formed on the upper surface of the base semiconductor layer 8. The second electrode E2 may be formed on the exposed portion of the base semiconductor layer 8. Then, the ridge portion RJ is formed in the compound semiconductor layer 9, and the insulating film DF and the first electrode E1 are formed. Thus, the semiconductor substrate 10 including the template substrate 7 and an element structure 22 formed on the template substrate 7 can be obtained.

Subsequently, a starting portion for cleavage is formed in the element structure 22. The starting portion for cleavage may be formed in the base semiconductor layer 8 or in the compound semiconductor layer 9. A method for forming the starting portion for cleavage is not limited. For example, the starting portion for cleavage may be formed by diamond scribing. In this case, since the starting portion can be formed in a thin shape, the starting portion for cleavage tends to be concentrated in one place. Accordingly, a smooth cleavage plane can be easily obtained. Note that since the insulating film DF formed on the compound semiconductor layer 9 is thin, the starting portion for cleavage can be formed in the compound semiconductor layer 9 without regard to presence of the insulating film DF. In the compound semiconductor layer 9, the insulating film DF may not be formed at the portion where the starting portion for cleavage is to be formed. That is, the compound semiconductor layer 9 may be exposed from the insulating film DF at the portion where the starting portion for cleavage is to be formed.

For example, the starting portion for cleavage may be formed by laser scribing. In this case, the yield can be improved because variation in scribe length can be reduced. The laser scribe length is a scanning distance of the laser. The starting portion for cleavage may be formed by dry etching or wet etching. In this case, cleavage proceeds without deviating from the cleavage plane, making it easier to obtain a smooth cleavage plane.

The starting portion for cleavage may be formed by combining the above techniques. In this case, the advantages of the respective techniques can be used simultaneously. The starting portion formed by diamond scribing or laser scribing may be further wet-etched. In this case, the starting portion for cleavage can be shaped. The starting portion formed by dry etching may be further wet-etched. In this case, the starting portion for cleavage can be shaped.

Subsequently, the element structure 22 in which the starting portion for cleavage is formed is cleaved. For example, cleavage may be generated at the starting portion by applying force in a direction perpendicular to the surface direction while applying a blade to the starting portion for cleavage. In this case, a strong force can be applied to the starting portion for cleavage, which improves the yield. Alternatively, cleavage may be generated at the starting portion by applying vibration to the starting portion for cleavage. In this case, the manufacturing process can be simplified because the process can be performed relatively easily.

Alternatively, by raising or lowering a temperature of the semiconductor substrate 10 from a room temperature, thermal stress utilizing a difference in thermal expansion coefficient between the main substrate 1 and the base semiconductor layer 8 may be applied to the starting portion to generate cleavage. When the difference in thermal expansion coefficient is utilized, variation of force applied within the plane is eliminated, improving the yield.

Alternatively, cleavage may be caused by applying stress to the element structure 22 on the template substrate 7 by curving the template substrate 7 with the main substrate 1 thinned by polishing or the like. In this case, the element structure 22 can be isolated to form the multiple element portions DS at once. Accordingly, manufacturing costs can be reduced.

The element structure 22 may be cleaved by combining the above cleavage techniques. In this case, the advantages of the respective techniques can be used simultaneously.

In Example 3, a timing of removing the mask portion 5 to separate the element portion DS from the template substrate 7 is preferably after the formation of the starting portion for cleavage or after cleavage. Thus, the formation of the starting portion or the cleavage can be stably performed, and the yield is improved.

In Example 3, internal stress may be generated in the base semiconductor layer 8 due to a difference in thermal expansion coefficient between the template substrate 7 and the base semiconductor layer 8. Internal stress may be generated in the base semiconductor layer 8 due to a difference in lattice constant between the template substrate 7 and the base semiconductor layer 8. The internal stress generated in the base semiconductor layer 8 tends to cause cleavage.

For example, internal stress is generated in the base semiconductor layer 8 and the compound semiconductor layer 9 due to a difference in thermal expansion coefficient between both the base semiconductor layer 8 and the compound semiconductor layer 9 and the main substrate 1. For example, when the base semiconductor layer 8 is formed on a heterogeneous substrate such as a Si substrate by the ELO method, the deposition temperature may be 1000°C or more. Accordingly, when the temperature is lowered to a room temperature, stress is generated in the base semiconductor layer 8. Due to the difference in lattice constant between the main substrate 1 and the base semiconductor layer 8, strain occurs in the base semiconductor layer 8.

When the thermal expansion coefficient of the main substrate 1 is larger than the thermal expansion coefficient of the base semiconductor layer 8, compressive stress is generated in the base semiconductor layer 8, and when the thermal expansion coefficient of the main substrate 1 is smaller than the thermal expansion coefficient of the base semiconductor layer 8, tensile stress is generated in the base semiconductor layer 8. The tensile stress generated in the base semiconductor layer 8 may cause cleavage by scribing the compound semiconductor layer 9. When cleaving the base semiconductor layer 8 under the tensile stress, the likelihood of divided pieces of the base semiconductor layer 8 coming into contact with each other can be reduced. Accordingly, the likelihood of end surfaces of the divided base semiconductor layer 8 being damaged can be reduced. When the element structure 22 is cleaved so as to be torn from the starting point by the tensile stress, the cleavage plane tends to be smooth.

For example, by scribing the base semiconductor layer 8, internal stress in the base semiconductor layer 8 may be released, and cleavage of the element structure 22 may proceed spontaneously. By scribing the compound semiconductor layer 9, internal stress in the base semiconductor layer 8 may be released, and cleavage of the element structure 22 may proceed spontaneously. "Cleavage proceeds spontaneously by scribing" means that scribing and cleavage occur at the same or substantially the same timing (cleavage occurs spontaneously with scribing). Thus, of the step of forming the starting portion (scribing step) and the step of cleaving the starting portion (breaking step), the latter can be omitted. Accordingly, manufacturing costs of the laser diode element 20 can be reduced.

Subsequently, the element portion DS is separated from the template substrate 7. Since the subsequent steps are the same as, and/or similar to those in Examples 1 and 2, the description thereof will be omitted.

As described above, in Example 3, the starting portion for cleavage can be formed at any position after the element structure is formed. Accordingly, the position at which the starting portion for cleavage is formed can be controlled. As a result, the position where cleavage occurs can be controlled, and the cavity length L1 can be adjusted. Therefore, the yield can be easily improved.

### Another Configuration of Example 3

In Example 3, after the step of forming the element structure, the step of forming the starting portion and the step of element isolation on the template substrate 7 are performed, but the order is not limited thereto. After performing the step of forming the starting portion, the step of forming the element structure may be performed, and then the step of element isolation on the template substrate 7 may be performed.

### Example 4

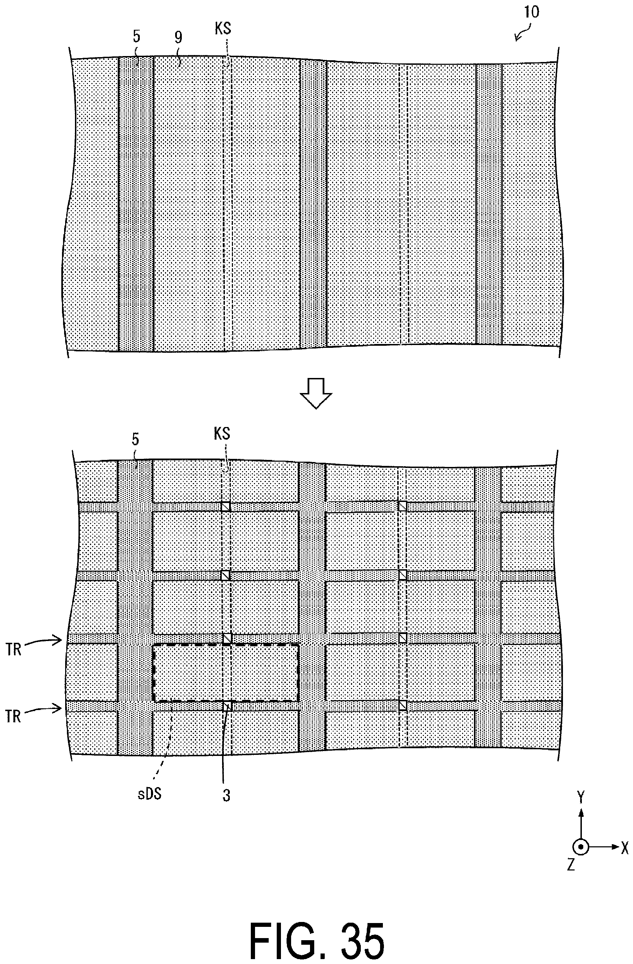

In Example 4, element isolation may be performed by etching instead of cleavage. FIG. 35 illustrates plan views of an example of element isolation in Example 4.

As illustrated in FIG. 35, after forming the base semiconductor layer 8 and the compound semiconductor layer 9 on the template substrate 7, etching is performed to form multiple trenches TR (isolation grooves) in the semiconductor substrate 10. Thus, on the template substrate 7, the base semiconductor layer 8 and the compound semiconductor layer 9 may be isolated into the multiple semi-element portions sDS including the optical cavities LK. The trench TR passes through the compound semiconductor layer 9 and the base semiconductor layer 8. The mask portion 5 and the seed layer 3 or the main substrate 1 may be exposed in the trench TR.

Note that etching may produce a taper angle at the end surface of the compound semiconductor layer 9 (the end surface may be deviated from the vertical). Accordingly, for example, the element isolation may be performed as follows. That is, first, the semiconductor substrate 10 is set in a slightly inclined state in an apparatus for an etching process. Subsequently, the trench TR is formed by etching, which corresponds to one side of the semi-element portion sDS in the Y direction that will be formed in the subsequent etching process. Thus, one of the pair of cavity surfaces (e.g., the emission surface F 1) of the semi-element portion sDS is formed. As a result, for example, the emission surface F1 can be formed vertically or substantially vertically. Subsequently, in the apparatus for the etching process, the semiconductor substrate 10 is set in a slightly inclined state to the opposite side (to the side opposite to when the above trench TR was formed). Then, the trench TR corresponding to the other side of the semi-element portion sDS in the Y direction is formed by etching. Thus, the other of the pair of cavity surfaces of the semi-element portion sDS (e.g., the facing surface F2) is formed. As a result, for example, the facing surface F2 can be formed vertically or substantially vertically.

### Example 5

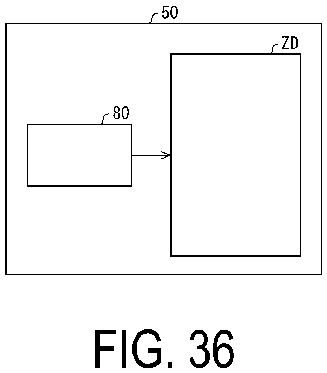

FIG. 36 is a schematic diagram illustrating a configuration of an electronic device in Example 5. An electronic device 50 in FIG. 36 includes a laser diode device ZD (the laser diode element 20 or the laser diode chip 21) and a controller 80 that includes a processor and controls the laser diode device ZD. Examples of the electronic device 50 include an illumination device, a display device, a communication device, an information processing device, a medical device, and an electric vehicle (EV).

### Example 6

In Example 1, the compound semiconductor part 9 is provided on the c-plane of the base semiconductor part 8, and the pair of cavity surfaces are the m-planes of the nitride semiconductor, but the configuration is not limited thereto. For example, the compound semiconductor part 9 may be provided on the m-plane ((1-100) plane) of the base semiconductor part 8, and the pair of cavity surfaces may be the c-plane ((0001) plane) of the nitride semiconductor. The cavity length L1 is a length in the c-axis direction. The emission surface F1 and the facing surface F2 can be formed, for example, by cleavage along the c-plane of the nitride semiconductor.

### Supplementary Note

In the present disclosure, the invention has been described above based on the various drawings and examples. However, the invention according to the present disclosure is not limited to each embodiment described above. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

1 Main substrate
5 Mask portion
5Y Starting point inducing portion
6 Mask layer (mask)
7 Template substrate
8 Base semiconductor layer (base semiconductor part)
8K, 9T Starting portion (starting point)
9 Compound semiconductor layer (compound semiconductor part)
20 Laser diode element (semiconductor device)
21 Laser diode chip
70 Manufacturing apparatus
B 1 First part
B2 Second part
B3 Third part
DS Element portion
E1 First electrode
E2 Second electrode
F1 Emission surface (cavity surface)
F2 Facing surface (cavity surface)
LK Optical cavity
RJ Ridge portion
sDS Semi-element portion (element portion)
SK Support substrate

## Claims

1. A method for manufacturing a semiconductor device comprising:
preparing a main substrate, a base semiconductor part formed above the main substrate, and a compound semiconductor part formed on the base semiconductor part; and
isolating the base semiconductor part and the compound semiconductor part with a cavity surface formed at least in the compound semiconductor part, and isolating the base semiconductor part and the compound semiconductor part into multiple element portions.

2. A method for manufacturing a semiconductor device comprising:
preparing a main substrate, a base semiconductor part formed above the main substrate, and a compound semiconductor part formed on the base semiconductor part; and
forming multiple optical cavities, each of the multiple optical cavities comprising a cavity surface by dividing both the base semiconductor part and the compound semiconductor part, wherein
in the forming of the multiple optical cavities, the main substrate is not divided, or the main substrate is divided into fewer pieces than the multiple optical cavities.

3. The method for manufacturing a semiconductor device according to claim 1 or 2, wherein
the base semiconductor part and the compound semiconductor part comprise a nitride semiconductor, and
the cavity surface is formed by cleavage of the base semiconductor part and the compound semiconductor part.

4. The method for manufacturing a semiconductor device according to claim 1 or 2, wherein
the cavity surface is formed by etching the base semiconductor part and the compound semiconductor part.

5. The method for manufacturing a semiconductor device according to any one of claims 1 to 4, the method further comprising:
after forming the cavity surface, separating an element portion comprising the cavity surface from the main substrate.

6. The method for manufacturing a semiconductor device according to claim 3, wherein
a mask is provided between the main substrate and the base semiconductor part,
the mask comprises a mask portion and an opening portion having a longitudinal shape, and
a notch is formed in the opening portion.

7. The method for manufacturing a semiconductor device according to claim 6, wherein
by forming the notch in the opening portion, a notch is spontaneously formed in the base semiconductor part, and
the notch in the base semiconductor part serves as a starting point of the cleavage.

8. The method for manufacturing a semiconductor device according to any one of claims 3, 6, and 7, wherein
a thermal expansion coefficient of the base semiconductor part and a thermal expansion coefficient of the compound semiconductor part are different from a thermal expansion coefficient of the main substrate.

9. The method for manufacturing a semiconductor device according to claim 8, wherein
the cleavage occurs spontaneously during cooling of the base semiconductor part and the compound semiconductor part.

10. The method for manufacturing a semiconductor device according to claim 3, wherein
after forming the base semiconductor part, a starting point for the cleavage is formed in the base semiconductor part.

11. The method for manufacturing a semiconductor device according to claim 3, wherein
after forming the compound semiconductor part, a starting point for the cleavage is formed in the compound semiconductor part.

12. The method for manufacturing a semiconductor device according to claim 10 or 11, wherein
the starting point is formed by diamond scribing.

13. The method for manufacturing a semiconductor device according to claim 10 or 11, wherein
the starting point is formed by laser scribing.

14. The method for manufacturing a semiconductor device according to claim 12 or 13, wherein
the starting point is further wet-etched.

15. The method for manufacturing a semiconductor device according to claim 10 or 11, wherein
the starting point is formed by etching.

16. The method for manufacturing a semiconductor device according to claim 15, wherein
the etching is dry etching, and
the starting point is further wet-etched.

17. The method for manufacturing a semiconductor device according to any one of claims 10 to 16, wherein
by changing temperatures of the base semiconductor part and the compound semiconductor part, the cleavage occurs from the starting point.

18. The method for manufacturing a semiconductor device according to any one of claims 10 to 16, wherein
by applying external force to the base semiconductor part and/or the compound semiconductor part, the cleavage occurs from the starting point.

19. The method for manufacturing a semiconductor device according to claim 3, wherein
the cleavage is caused by scribing the compound semiconductor part.

20. The method for manufacturing a semiconductor device according to claim 3, wherein
the compound semiconductor part comprises a GaN-based semiconductor, and
the cavity surface is an m-plane of the compound semiconductor part.

21. The method for manufacturing a semiconductor device according to any one of claims 1 to 20, wherein
the main substrate and the base semiconductor part have different lattice constants.

22. The method for manufacturing a semiconductor device according to claim 21, wherein
the main substrate is a silicon substrate.

23. The method for manufacturing a semiconductor device according to claim 21, wherein
the base semiconductor part contains a GaN-based semiconductor.

24. The method for manufacturing a semiconductor device according to any one of claims 1 to 23, wherein
a first electrode and a second electrode located above the compound semiconductor part are formed.

25. The method for manufacturing a semiconductor device according to any one of claims 1 to 24, wherein
the base semiconductor part comprises a first portion and a second portion having a threading dislocation density of one fifth or less of a threading dislocation density of the first portion.

26. The method for manufacturing a semiconductor device according to any one of claims 1 to 25, wherein
the compound semiconductor part comprises a first type semiconductor part, an active part, and a second type semiconductor part in this order.

27. The method for manufacturing a semiconductor device according to claim 25, wherein
an element portion comprising the cavity surface comprises a ridge structure overlapping the second portion in plan view.

28. The method for manufacturing a semiconductor device according to claim 25, wherein
the threading dislocation density of the second portion is 5 × 10⁶/cm² or less.

29. The method for manufacturing a semiconductor device according to any one of claims 1 to 28, wherein
the base semiconductor part is formed by an ELO method.

30. A template substrate comprising:
a main substrate;
a seed part; and
a mask, wherein
the mask comprises an opening portion having a longitudinal shape and a mask portion, and
a notch is provided in the opening portion.

31. A semiconductor device comprising:
a base semiconductor part; and
a compound semiconductor part located above the base semiconductor part and comprising an optical cavity comprising a pair of cavity surfaces, wherein
the base semiconductor part and the compound semiconductor part comprise a GaN-based semiconductor, and
the base semiconductor part comprises a cleavage plane being an m-plane of the GaN-based semiconductor.

32. The semiconductor device according to claim 31, wherein
the base semiconductor part comprises
(i) a first base end surface comprising the cleavage plane being the m-plane of the GaN-based semiconductor, and
(ii) a second base end surface at an angle and adjacent to the first base end surface, the second base end surface not being a cleavage plane.

33. The semiconductor device according to claim 32, wherein
an internal angle between the first base end surface and the second base end surface is an obtuse angle.

34. The semiconductor device according to claim 32 or 33, wherein
the base semiconductor part comprises a third base end surface at an angle and adjacent to the second base end surface and parallel to an a-plane of the GaN-based semiconductor.

35. An electronic device, comprising:
the semiconductor device according to any one of claims 31 to 34.

36. A manufacturing apparatus for a semiconductor device, wherein
the manufacturing apparatus performs
preparing a main substrate, a base semiconductor part formed above the main substrate, and a compound semiconductor part formed on the base semiconductor part, and
isolating the base semiconductor part and the compound semiconductor part with a cavity surface formed at least in the compound semiconductor part, and isolating the base semiconductor part and the compound semiconductor part into multiple element portions.
